(19) Europäisches Patentamt
European Patent Office
Office européen des brevets

(11) EP 4 168 813 B1

(12) # EUROPÄISCHE PATENTSCHRIFT

(45) Veröffentlichungstag und Bekanntmachung des Hinweises auf die Patenterteilung:
**05.03.2025 Patentblatt 2025/10**

(21) Anmeldenummer: **21777767.1**

(22) Anmeldetag: **16.09.2021**

(51) Internationale Patentklassifikation (IPC):
***G01R 31/392*** *(2019.01)* ***G01R 31/367*** *(2019.01)*

(52) Gemeinsame Patentklassifikation (CPC):
**G01R 31/392; G01R 31/367**

(86) Internationale Anmeldenummer:
**PCT/EP2021/075462**

(87) Internationale Veröffentlichungsnummer:
**WO 2022/058416 (24.03.2022 Gazette 2022/12)**

(54) **BESTIMMUNG EINES ALTERUNGSZUSTANDS EINES ENERGIESPEICHERS**
DETERMINATION OF A STATE OF HEALTH OF AN ENERGY STORE
DÉTERMINATION D'UN ÉTAT DE SANTÉ D'UN ACCUMULATEUR D'ÉNERGIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.09.2020 DE 102020124182**

(43) Veröffentlichungstag der Anmeldung:
**26.04.2023 Patentblatt 2023/17**

(73) Patentinhaber: **TWAICE Technologies GmbH**
**80807 München (DE)**

(72) Erfinder:
- **KEIL, Jonas**
  **80337 München (DE)**
- **MEIßNER, Michael**
  **85604 Zorneding (DE)**
- **GOKULAKRISHNAN, Gokulakrishnan**
  **85748 Garching bei München (DE)**
- **WANISCH, Manuel**
  **80639 München (DE)**

(74) Vertreter: **Kraus & Lederer PartGmbB**
**Thomas-Wimmer-Ring 15**
**80539 München (DE)**

(56) Entgegenhaltungen:
**WO-A1-2017/142585** **DE-A1- 102018 220 494**
**DE-B3- 102018 215 575**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).



Processed by Luminess, 75001 PARIS (FR)

## Beschreibung

Die vorliegende Erfindung betrifft ein Gerät zum Bestimmen eines Alterungszustands eines Energiespeichers, insbesondere einer wiederaufladbaren Batterie, weiterhin werden ein entsprechendes Verfahren, ein Computerprogramm und ein elektronisch lesbarer Datenträger bereitgestellt.

Technischer Hintergrund

Wiederaufladbare Batterien altern sowohl während der Lagerung (kalendarische Alterung) als auch während des Betriebs (zyklische Alterung). Eine Alterung kann beispielsweise eine Kapazitätsabnahme und/oder eine Zunahme der Impedanz bedeuten. Somit kann die Energie und Leistung einer Batterie abnehmen, sodass sich beispielsweise für ein batteriebetriebenes Elektrofahrzeug die Reichweite verringert und das Beschleunigungsverhalten verschlechtert.

Um den aktuellen Alterungszustand (engl. State Of Health, SOH) einer Batterie bestimmen zu können, benötigt man die aktuelle sowie eine initiale (nominale) bekannte Batteriekapazität, bzw. die aktuelle sowie die initiale bekannte (nominale) Batterieimpedanz. Die aktuelle Batteriekapazität muss dabei exakt so gemessen werden wie die initiale Batteriekapazität, da sie wesentlich von der Anfangs- und Endspannung, dem Strom und -protokoll sowie der Umgebungstemperatur und Temperierung, sowie weiteren hier beschriebenen Parametern, abhängen können. In Labormessungen werden diese Randbedingungen/Parameter mit festen Werten definiert, was allerdings in realen Anwendungen nicht der Fall ist.

Somit lässt sich der SOH einer Batterie in realen Anwendungen durch einen direkten Vergleich von Ladephasen und/oder Entladephasen im Allgemeinen nicht bestimmen, da sich die Randbedingungen, unter anderem Lade-/Entladeparameter wie beispielweise Spannungsfenster, Strom, Temperatur, bei jeder Lade-/Entladephase unterscheiden.

Ein relevantes Dokument aus dem Stand der Technik ist WO 2017/142585 A1, welches die Bestimmung eines Alterungsverfahrens eines Energiespeichers mittels Regression betrifft. Dabei wird offenbart die Batteriekapazität, welche dem SOH entspricht, zu bestimmen. Für diese Bestimmung werden verschiedene Größen wie Strom und Spannung gemessen und ein Ladungsdurchsatz upgedated.

Zusammenfassung

Daher besteht Bedarf an verbesserten Techniken zum Bestimmen eines Alterungszustands eines Energiespeichers, die zumindest einige der genannten Einschränkungen und Nachteile überwinden oder abmildern.

Diese Aufgabe wird mit den Merkmalen der unabhängigen An-sprüche gelöst. In den abhängigen Ansprüchen sind weitere vorteilhafte Ausführungsbeispiele beschrieben.

Im Folgenden wird die erfindungsgemäße Lösung in Bezug auf die beanspruchten Geräte und die beanspruchten Verfahren, als auch einen Energiespeicher, ein Energiesystem, ein Computerprogramm und Datenträger und eine verteilte Datenbank beschrieben. Merkmale, Vorteile oder alternative Ausführungsbeispiele können den jeweils anderen Kategorien zugeordnet werden, und umgekehrt. In anderen Worten, die Ansprüche für das Gerät können durch Merkmale verbessert werden, die im Rahmen der Verfahren beschrieben und/oder beansprucht werden, und umgekehrt kann das Verfahren beliebige Schritte umfassen, die im Rahmen der Geräte beschrieben sind.

Ein Gerät zum Bestimmen eines Alterungszustands eines Energiespeichers ist konfiguriert, um einen ersten Datensatz, umfassend erste Vorgangsdaten und eine erste reale (sich aus dem gemessenen Strom ergebende) Vorgangskapazität, mindestens eines ersten Ladevorgangs oder eines Entladevorgangs, kurz Lade-/Entladevorgang oder Vorgang, eines Energiespeichers zu umfassen. Es ist zu verstehen, dass die Techniken entsprechend der vorliegenden Beschreibung gleichermaßen auf Ladevorgänge und auf Entladevorgänge angewendet werden können, wobei beispielsweise für eine Technik nur Ladevorgänge oder nur Entladevorgänge eines Energiespeichers verwendet werden können.

Ein Gerät kann beispielsweise einen Prozessor, und/oder eine Speichereinheit zum Speichern von Programmbefehlen, und/oder eine Schnittstelle (Interface) zum Senden/Empfangen von Daten, umfassen.

Vorgangsdaten eines Lade-/Entladevorgangs können beispielsweise Messdaten mindestens des mindestens einen Lade-/Entladevorgangs, insbesondere Zeitreihen von Messwerten des Stroms, und/oder der Spannung und/oder der Temperatur des Energiespeichers während eines jeweiligen Lade-/Entladevorgangs umfassen, und/oder Parameter und/oder Entladeparameter, kurz Lade-/Entladeparameter oder Parameter, eines Ladevorgangs oder eines Entladevorgangs, beispielsweise basierend auf den Messwerten eines jeweiligen Lade-/Entladevorgangs, umfassen. In diesem Zusammenhang kann ein einzelner Lade-/Entladevorgang eines Energiespeichers jeweils durch viele Messwerte, d.h. Messkurven, des Vorgangs charakterisiert sein, und durch Parameter, d.h. Lade- und/oder Entladeparameter, welche sich aus den Messwerten der jeweiligen Vorgänge ergeben können. Diese Daten werden hier als Vorgangsdaten beschrieben, die dem jeweiligen Lade-/Entladevorgang zugeordnet sein können.

Eine Vorgangskapazität eines Lade-/Entladevorgangs, in anderen Worten eine reale oder gemessene Vorgangskapazität, kann sich aus den Messdaten ergeben, und einer realen Energiemenge entsprechen, die dem Energiespeicher während des Vorgangs zugeführt oder entnommen wird. Es ist jedoch auch denkbar, dass die reale Vorgangskapazität durch weitere Sensoren oder extern von dem Energiespeicher gemessen und/oder bereitgestellt werden könnte. Eine reale Vorgangskapazität kann beispielsweise aus Messdaten eines Lade-/Entladevorgangs, insbesondere aus dem Stroms, bestimmt sein, beispielsweise durch Akkumulieren eines Ladungsdurchsatzes während des Lade-/Entladevorgangs, beispielsweise durch Integrieren des Stroms über Zeit.

Beispielsweise kann jedem Lade-/Entladevorgang kann ein Datensatz zugeordnet sein, welcher Vorgangsdaten und eine reale Vorgangskapazität des jeweiligen Vorgangs umfasst.

Ein Umfassen kann in einigen Beispielen auch ein Empfangen oder ein Bestimmen oder Erfassen von Vorgangsdaten, Vorgangskapazitäten, Messdaten, und/oder Lade-/Entladeparametern einschließen.

Das Gerät kann beispielsweise konfiguriert sein, um Messwerte eines Lade-/Entladevorgangs zu empfangen und/oder zu speichern, und daraus die jeweiligen Lade-/Entladeparameter zu bestimmen, oder die Parameter zu empfangen und/oder zu speichern. Die Messwerte eines Lade-/Entladevorgangs können dabei in einem Speicher gespeichert werden, beispielsweise in einer Cloud, in einer verteilten Datenbank, einem zentralen Speicher eines Energiesystems, lokal in einem Speicher des Energiespeichers, oder lokal in einem Speicher des Geräts. Die Messwerte können von einem oder mehreren Sensoren erfasst sein, welche an dem Energiespeicher, oder einem Ladegerät des Energiespeichers, angeordnet sind, oder im Allgemeinen in einer Leitung zwischen einer Energiequelle oder Energieverbraucher und dem Energiespeicher geschaltet sein können. Die Messwerte können insbesondere eine Zeitreihe von aufeinanderfolgenden Messwerten des Stroms, der Spannung, oder einer Temperatur, während des Lade-/Entladevorgangs, umfassen.

Das Gerät kann beispielsweise auch weiter konfiguriert sein, den Lade-/Entladevorgang an einem Energiespeicher durchzuführen. Das Gerät kann dabei konfiguriert sein, während des Lade-/Entladevorgangs einen Strom, eine Spannung, und eine Temperatur des Energiespeichers, über Zeit d.h. als Messkurve, oder zeitlichen Verlauf von Messpunkten, zu umfassen, zu messen und/oder und zu speichern. Das Gerät kann konfiguriert sein, einen Lade-/Entladevorgang des Energiespeichers zu bestimmen. Das Gerät kann weiter konfiguriert sein, einen Beginn und/oder ein Ende eines Lade-/Entladevorgangs zu bestimmen, in anderen Worten ein Durchführen eines Lade-/Entladevorgangs zu bestimmen, um basierend darauf die Vorgangsdaten zu bestimmen.

In einigen Beispielen kann ein Energiespeicher eine Vielzahl von Lade-/Entladevorgängen und/oder Lade-/Entladevorgängen erfahren, bei welchen es sich insbesondere um Felddaten im Betrieb handeln kann. Dabei kann der mindestens eine erste Lade-/Entladevorgang eine erste Vielzahl von ersten Lade-/Entladevorgängen oder Lade-/Entladevorgängen des Energiespeichers umfassen. In anderen Worten kann statt einem ersten Lade-/Entladevorgang eine erste Gruppe, oder Teilmenge, von Lade-/Entladevorgängen der Vielzahl von Lade-/Entladevorgängen des Energiespeichers, umfassen. Entsprechend kann das Gerät eine Vielzahl von Datensätzen umfassen, wobei in einem jeweiligen Datensatz die Vorgangsdaten und reale Vorgangskapazität eines entsprechenden Lade-/Entladevorgangs umfasst sein können. Durch eine Vielzahl von ersten Lade-/Entladevorgängen kann das erste Ladekapazitätsmodell genauer bestimmt werden.

Ein Alterungszustand des Energiespeichers kann relativ zu einem anderen Alterungszustand bestimmt sein. Somit kann ein Bestimmen eines Alterungszustands ein Bestimmen einer Alterung, d.h. eines Unterschieds, umfassen, beispielsweise eine absolute Differenz einer Vorgangskapazität (in Ah) oder ein relatives Verhältnis (z.B. Prozentsatz), zwischen einem ersten Alterungszustand und einem zweiten Alterungszustand, um eine Alterung darzustellen.

Der mindestens eine erste Lade-/Entladevorgang kann einem ersten Alterungszustand entsprechen, und der mindestens eine zweite Lade-/Entladevorgang kann einem zweiten Alterungszustand entsprechen. Somit können sich alle Lade-/Entladevorgänge, Vorgangsdaten, Vorgangskapazitäten und Parameter, die mit "erste" gekennzeichnet sind, auf einen ersten Alterungszustand des Energiespeichers beziehen, und alle Lade-/Entladevorgänge, Vorgangsdaten, Vorgangskapazitäten und Parameter, die mit "zweite" gekennzeichnet sind, auf einen zweiten Alterungszustand des Energiespeichers beziehen, in anderen Worten dem Alterungszustand des Energiespeichers entsprechen oder während dem Alterungszustand des Energiespeichers durchgeführt bzw. erfasst oder bestimmt sein.

Die vorliegende Erfindung beruht auf der Erkenntnis, dass Lade-/Entladevorgänge unterschiedliche Vorgangskapazitäten und/oder unterschiedliche Lade-/Entladezeitdauern, und/oder unterschiedliche Ströme und/Spannungen aufweisen, und dadurch nicht direkt vergleichbar sind. Somit kann beispielsweise nicht durch einen direkten Vergleich zweier Ladevorgänge bestimmt werden, dass ein Energiespeicher während eines zweiten Lade-/Entladevorgangs einen veränderten Alterungszustand im Vergleich zu einem ersten Lade-/Entladevorgang aufweist.

Für einen ersten Alterungszustand, der durch mindestens einen ersten Lade-/Entladevorgang, vorteilhaft einer ersten Gruppe von Lade-/Entladevorgängen, repräsentiert wird, kann ein Modell aufgebaut werden, unter Verwenden der vorhandenen Daten, d.h. Datensätzen für jeden der ersten Lade-/Entladevorgänge. Das Modell berechnet für einen Lade-/Entladevorgang eine simulierte Vorgangskapazität. Somit wird unter Verwenden des mindestens einen Datensatzes, vorteilhaft einer Vielzahl von Datensätzen einer Gruppe von Lade-/Entladevorgängen, ein Modell aufgebaut, welches basierend auf den Vorgangsdaten eines Lade-/Entladevorgangs eine Vorgangskapazität des Vorgangs simuliert (simulierte Vorgangskapazität). In anderen Worten, das Modell ist ein Modell zur Bestimmung einer Ladekapazität und/oder Entladekapazität eines Lade-/Entladevorgangs eines Energiespeichers, in anderen Worten einer Vorgangskapazität, aus Messdaten und/oder Parametern des Vorgangs.

In anderen Worten ein Modell zur Berechnung einer Vorgangskapazität kann einem Alterungszustand entsprechen und spezifisch für den Alterungszustand sein, d.h. es kann durch einen Alterungszustand charakterisieren. In einem ersten Alterungszustand des Energiespeichers kann ein erstes Modell einen beliebigen Lade-/Entladevorgang zutreffend beschreiben, in einem zweiten Alterungszustand des Energiespeichers kann ein zweites Modell, das sich von dem ersten Modell unterscheidet, einen beliebigen Lad- /Entladezustand zutreffend beschreiben. In diesem Zusammenhang können eine oder mehrerer Lade-/Entladephasen jeweils einem Alterungszustand zugeordnet sein, d.h. durchgeführt werden während der Energiespeicher sich in dem Alterungszustand befindet.

In einigen Beispielen kann nun ein Modell zur Berechnung einer Lade-/Entladekapazität eines Lade-/Entladevorgangs aufgebaut und/oder trainiert werden, so dass es einen beliebigen Lade-/Entladevorgang während eines ersten Alterungszustandes aus Vorgangsdaten berechnet. Ein zweiter Alterungszustand des Energiespeichers kann nun mit Hilfe des Modells berechnet werden, indem man basierend auf dem Modell eine simulierte Vorgangskapazität, die zum Beispiel keiner der ersten Lade-/Entladevorgängen entspricht, berechnet und mit einer zweiten Vorgangskapazität vergleicht.

In anderen Worten, durch Anwenden eines Modells, das einen ersten Alterungszustand charakterisiert, auf einen Ladevorgang eines zweiten Alterungszustandes kann eine Veränderung von dem ersten zu dem zweiten Alterungszustand bestimmt werden. Weiter kann auch für den zweiten Alterungszustand ein Modell bestimmt werden, und das erste und das zweite Modell können verglichen werden, beispielsweise Modellparameter, oder durch ein Anwenden beider Modelle auf einen gleichen Lade-/Entladevorgang.

Im Allgemeinen kann eine Ausgabe eines Modells auch ein beliebiger Kennwert eines Lade-/Entladevorgangs sein, welcher von dem aktuellen Alterungszustand des Energiespeichers abhängen kann. Es kann vorstellbar sein, dass als derartiger alterungsspezifischer Kennwert eines Lade-/Entladevorgangs beispielsweise eine Integrierung oder eine Differenzierung von Messwerten, wie beispielsweise des Stroms oder der Spannung, über Zeit oder in Bezug aufeinander, oder eine Kombination davon, umfasst sein können.

Das Gerät ist konfiguriert, um ein erstes Modell für den mindestens einem ersten Lade-/Entladevorgang des Energiespeichers zu erzeugen, basierend dem mindestens einen zu dem Lade-/Entladevorgang zugehörigen Datensatz bzw. den Datensätzen einer Vielzahl von ersten Lade-/Entladevorgängen. Das erste Modell berechnet eine Vorgangskapazität des ersten Lade-/Entladevorgangs durch Anwenden des ersten Modells auf die ersten Vorgangsdaten des ersten Lade-/Entladevorgangs. Im Allgemeinen wird durch Anwenden eines Modells auf die Vorgangsdaten eine simulierte Vorgangskapazität des Lade-/Entladevorgangs basierend auf (in anderen Worten unter Verwenden von) den Vorgangsdaten und dem Modell berechnet.

Ein Erzeugen eines Modells kann ein Aufbauen und Bereitstellen des Modells, d.h. ein Generieren von Modellparametern (parametrisieren) und/oder ein Anpassen von Werten von Modellparametern des Modells (parametrieren), d.h. ein Anpassen oder Trainieren des Modells, umfassen. Beispielsweise kann ein Trainieren ein Anwenden des Modells auf eine Vielzahl von Vorgangsdaten von Lade-/Entladevorgängen umfassen, wobei Funktionsparameter oder Modellparameter des Modells angepasst werden können, so dass das Modell die Vorgangskapazitäten der Ladevorgänge mit minimiertem Fehler verglichen mit den realen Vorgangskapazitäten berechnet. Die Vorgangsdaten eines Lade-/Entladevorgangs können beispielsweise ein Eingangsdatensatz und eine simulierte Vorgangskapazität ein Ausgangsdatensatz sein. Durch Vergleich mit der bekannten realen Vorgangskapazität des Lade-/Entladevorgangs kann das Modell angepasst werden, wobei ein Modellfehler zwischen der simulierten und realen Vorgangskapazität minimiert wird. Ein Modellfehler, der bei einem Erzeugen eines Modells bestimmt wird, kann in Folge dazu verwendet werden, eine simulierte Kapazität zu bewerten oder zu charakterisieren, beispielsweise bezüglich einer Genauigkeit oder Zuverlässigkeit.

Ein Eingangsdatensatz kann beispielsweise auch weitere Eingangsdaten umfassen, wie beispielsweise Messwerte und/oder Parameter und/oder weitere Parameter wie Batterieparameter und/oder Betriebsparameter und/oder Vorgangsdaten einer unmittelbar vorhergehenden Entladephase und/oder Ruhephase der Batterie, welche beispielsweise einen zeitlich unmittelbar vor dem Lade-/Entladevorgang gelegenen Betrieb des Energiespeichers charakterisieren können. In einigen Beispielen können die Betriebsparameter des Energiespeichers angeben, ob der Energiespeicher vor dem einem Lade-/Entladevorgang in Ruhe war, d.h. ohne Energiezufuhr oder Entnahme, einen Strom in einer zeitlich unmittelbar vor dem Lade-/Entladevorgang vorhergehenden Entladephase umfassen, oder eine unmittelbar vorhergehende Zeitdauer, in welcher der Energiespeicher vor dem Laden keine Entladung und/oder Ladung erfahren hat.

Unter Verwenden von Vorgangsdaten und realer Vorgangskapazitäten kann das trainierbare Modell somit Ende-zu-Ende trainiert werden, sodass durch Anwenden des trainierten Modells auf einen Eingangsdatensatz (umfassend z.B. Messwerte und/oder Parameter, und/oder weitere Parameter wie Batterieparameter und/oder Betriebsparameter und/oder Betriebskennwerte) als Ausgabe direkt eine Vorgangskapazität ausgegeben werden kann.

Das Gerät ist konfiguriert, um zweite Vorgangsdaten und eine entsprechende zweite Vorgangskapazität mindestens eines zweiten Lade-/Entladevorgangs zu umfassen. Die zweite Vorgangskapazität kann beispielsweise einem bekannten Alterungszustand des Energiespeichers entsprechen. Zum Beispiel können die zweiten Vorgangsdaten und die zugehörige zweite Vorgangskapazität aus einem beliebigen bekannten Zustand des Energiespeichers, beispielsweise einem initialen, oder neuen Zustand bei Auslieferung des Energiespeichers, oder einen Zustand, der sich aus einem Datenblatt des Energiespeichers ergibt, entsprechen. Beispielsweise können die zweiten Vorgangsdaten und die zweie Vorgangskapazität einem Lade-/Entladeprotokoll des Energiespeichers entsprechen, welches für einen bekannten Alterungszustand des Energiespeichers angegeben sind. Zum Beispiel kann ein beliebiger Lade-/Entladevorgang ausgewählt werden, von dem Vorgangsdaten und eine Vorgangskapazität bekannt sind, beispielsweise aus einem Datenblatt, oder ein Vollzyklus des Energiespeichers.

Das Gerät ist weiter konfiguriert, einen Alterungszustand des Energiespeichers zu bestimmen, unter Verwenden des ersten Modells, der zweiten Vorgangsdaten und der zweiten Vorgangskapazität. Beispielsweise kann das Gerät konfiguriert sein, durch ein Vergleichen einer simulierten Vorgangskapazität eines Lade-/Entladevorgangs basierend auf dem ersten Modell zum Berechnen einer Lade-/Entladekapazität und zweiten Vorgangsdaten eines Lade-/Entladevorgangsmit mit einer reellen oder bekannten zweiten Lade/Entladekapazität für die zweiten Vorgangsdaten einen Alterungszustand des Energiespeichers zu bestimmen.

Wie oben beschrieben kann die zweite Vorgangskapazität einem bekannten, z.B. initialen, Zustand des Energiespeichers entsprechen, oder kann einem beliebigen (zum gegenüber dem ersten Alterungszustand gealterten) zweiten Alterungszustand entsprechen. Das Gerät kann somit konfiguriert sein, um zweite Vorgangsdaten und eine zweite Vorgangskapazität mindestens eines zweiten realen Lade-/Entladevorgangs des Energiespeichers zu umfassen.

Entsprechend der Beschreibung für den mindestens einen ersten Lade-/Entladevorgang, kann auch der mindestens eine zweite Lade-/Entladevorgang mehrere Ladevorgänge umfassen, beispielsweise eine zweite Teilmenge der Vielzahl von Lade-/Entladevorgängen eines Energiespeichers, wobei für jeden der Ladevorgänge entsprechende Vorgangsdaten und eine entsprechende Vorgangskapazität umfasst sein können. **In** anderen Worten, sowohl das erste Modell als auch das zweite Modell können jeweils auf einer Vielzahl von Datensätzen erstellt oder trainiert werden, wobei jeder Datensatz einem Lade-/Entladevorgang entspricht und die entsprechenden Vorgangsdaten sowie eine entsprechende reale Vorgangskapazität enthält. Dadurch sind verschiedene Verfahren möglich, um einen Alterungszustand zu bestimmen, die im Folgenden genauer beschrieben werden.

Vorgangsdaten eines Lade-/Entladevorgangs können beispielsweise einen Satz von Parametern eines jeweiligen Lade-/Entladevorgangs umfassen, zum Beispiel können die ersten Vorgangsdaten mindestens einen ersten Satz von Parametern des mindestens einen ersten Lade-/Entladevorgangs umfassen, und die zweiten Vorgangsdaten mindestens einen zweiten Satz von Parametern des mindestens einen zweiten Lade-/Entladevorgangs umfassen, wobei der erste und der zweite Satz von Parametern eine beliebige Kombination der folgenden Parameter des jeweiligen Lade-/Entladevorgangs umfassen können:

- einer Anfangsspannung (U_BOC);
- einer Endspannung (U_EOC);
- einem maximalen Strom (I_max);
- einem durchschnittlichen Strom während einer Konstantstrom-Ladephase (I_mean_CC);
- einem durchschnittlichen Strom während einer Konstantspannungs-Ladephase (I_mean_CV);
- einer Zeitdauer ab Beginn des Lade-/Entladevorgangs an dem zwischen einer Konstantstrom-Ladephase und einer Konstantspannungs-Ladephase umgeschaltet wird
- einem Abschaltstrom (I_EOC) in einer Konstantspannungs-Ladephase,
- einer minimalen Temperatur des Energiespeichers, und
- einer maximalen Temperatur des Energiespeichers,
- Ladekapazität in einer Konstantstrom-Ladephase und Ladekapazität in einer Konstantspannungs-Ladephase,
- Entladekapazität in einer Konstantstrom-Entladephase und Entladekapazität in einer Konstantspannungs-Entladephase,
- Entladekapazität in der dynamischen Entladephase und Ladekapazität in der Rekuperationsphase,
- Lade-/Entladeparameter unter Berücksichtigung der Polarisation der Batterie,
- einen Polarisationszustand des Energiespeichers, d.h. einen Polarisationsparameter, der repräsentiert, wie stark der Energiespeicher polarisiert ist,
- Lade-/Entladeparameter vor/während Polarisation der Batterie,
- Mittlerer Lade-/Entladestrom,
- Standardabweichung Lade-/Entladestrom,
- Gleichstromwiderstand,
- Wechselstromwiderstand,
- Lastkollektive von Strom, Spannung, Temperatur, Kapazität,
- Zyklen und Halbzyklen,

- Mittlere Temperatur,
- Maximale Temperatur,
- Mittelwerte von Lade-/Entladeparametern,
- Maximale und minimale Werte von Lade-/Entladeparametern,
- Differenzen aus maximalen und minimalen Werten (Delta Berechnung), und
- Gradienten von Lade-/Entladeparametern, z. B. dV/dQ, dV/dt, dV/dT, dT/dQ.

Ist zu verstehen, dass die Techniken gemäß der vorliegenden Offenbarung auf eine beliebige spezifische Teilmenge, beispielsweise eine beliebige spezifische Kombination, der genannten Parameter eingeschränkt werden kann.

Das erste und/oder das zweite Modell können jeweils auf den ersten und/oder zweiten Satz von Parametern angewendet werden.

Durch einen erfindungsgemäßen Vergleich mittels eines Kapazitätsmodells für Lade-/Entladevorgänge, die wegen unterschiedlichen Parameter nicht unmittelbar vergleichbar sind, kann ein Alterungszustandes Energiespeichers präzise bestimmt werden.

Parameter eines Lade-/Entladevorgangs können den Lade-/Entladevorgang, oder - phase, in welchem dem Energiespeicher elektrische Energie zugeführt wird, charakterisieren oder definieren. Zum Beispiel können Parameter einen oder mehrere Kennwerte, d.h. spezifische Strom- oder Spannungswerte aus einer Strom- oder Spannungskurve umfassen. Beispielsweise können während einem Ladungsvorgang der Strom oder die Spannung, in anderen Worten ein zeitlicher Verlauf der Messgrößen, von einem oder mehreren Sensoren an dem Energiespeicher oder einer Ladungsenergiequelle oder Verbraucher gemessen und aufgezeichnet/gespeichert werden.

Die Lade-/Entladevorgänge der erfindungsgemäßen Verfahren können unter unterschiedlichen Lade-/Entladebedingungen durchgeführt sein, indem einer oder mehrere Parameter unterschiedliche Werte aufweisen. Insbesondere können die Lade-/Entladevorgänge, die unterschiedlichen Alterungszuständen entsprechen, unterschiedliche Kapazitäten, und/oder Zeitdauern, und/oder Ströme, und/oder Spannungen aufweisen. Beispielsweise kann der mindestens eine erste Lade-/Entladevorgang von dem mindestens einen zweiten Lade-/Entladevorgang unterschiedlich sein, indem ein oder mehrere Parameter unterschiedliche Werte aufweisen. In einigen Beispielen können alle Ladevorgänge in der ersten Teilmenge von Lade-/Entladevorgängen und/oder alle Ladevorgänge in der zweiten Teilmenge von Lade-/Entladevorgängen unterschiedlich sein. Zumindest ein Teil oder alle der Ladevorgänge, die zur Bestimmung eines Alterungszustandes simuliert, d.h. verglichen werden, können unterschiedliche Parameterwerte aufweisen.

Das Modell kann auf einen Satz von Parametern angewendet werden. Beispielsweise kann das Modell auf den ersten Satz von Parametern angewendet werden, wodurch eine erste simulierte Vorgangskapazität berechnet, oder bestimmt wird. Beispielsweise kann das Modell in gleicher Weise auf einen zweiten Satz von Parametern angewendet werden, wodurch eine zweite simulierte Vorgangskapazität berechnet, oder bestimmt wird. In diesem Zusammenhang können sich die Parameter des ersten Satzes von Parametern und die Parameter des zweiten Satzes von Parametern paarweise entsprechen, wobei gemeint ist, dass beispielsweise ein Paar von sich entsprechenden Parametern auf die gleiche Art und Weise im Modell enthalten sind, also durch das Modell auf die gleiche Art und Weise verwendet werden. Sich entsprechende Parameter des ersten und des zweiten Satzes von Parametern können im Allgemeinen unterschiedliche Werte aufweisen. Beispielsweise können ein Paar von sich entsprechenden Parametern aus dem ersten und dem zweiten Satz von Parameter unterschiedliche Werte aufweisen, oder mehrere Paare, oder alle Paare.

Im Allgemeinen kann somit der erste Satz von Parameter dem zweiten Satz von Parameter zumindest teilweise paarweise entsprechen, d.h. das Modell kann in gleicher Weise auf beide Sätze von Parametern angewendet werden, und die entsprechenden Parameter können zumindest teilweise unterschiedliche Werte aufweisen, wodurch die Lade-/Entladevorgänge, insbesondere die Kapazitäten der Lade-/Entladevorgänge, nicht direkt vergleichbar sind, um einen Alterungszustand des Energiespeichers zu bestimmen. Insbesondere kann der erste Satz von Parametern dem zweiten Satz von Parametern vollständig entsprechen, wobei sich die ersten Parameter und die zweiten Parameter paarweise entsprechen können, und/oder wobei die alle sich entsprechenden Parameter unterschiedliche Werte aufweisen können. Die Vorgangskapazität des ersten und des zweiten Vorgangs kann unterschiedlich sein. Dadurch können der erste bzw. zweite Lade-/Entladevorgang nicht mehr direkt verglichen werden, um einen Alterungszustand zu ermitteln.

Der Ausdruck zumindest teilweise unterschiedlich, soll insbesondere Beispiele umfassen, in denen die Anfangsspannung, und/oder die Endspannung, und/oder der Strom, und/oder der Ladungsdurchsatz, und/oder der Abschaltstrom, und/oder die Temperatur des Energiespeichers von jeweiligen Lade-/Entladevorgängen unterschiedlich ist. Es ist zu verstehen, dass das oben Gesagte entsprechend in gleicher Weise für einen beliebigen Satz von Parametern eines beliebigen Lade-/Entladevorgangs gelten kann.

Das Gerät kann konfiguriert sein, einen aktuellen Alterungszustand, d.h. eine aktuelle Energiespeicherkapazität, oder eine aktuelle Impedanz des Energiespeichers, bereitzustellen. Der aktuelle Alterungszustand, die aktuelle Energiespeicherkapazität, und die aktuelle Impedanz eines Energiespeichers können als prozentualer Wert ihrer initialen Werte (d.h. ohne Alterung) oder in Bezug auf einen anderen Alterungszustand ausgegeben werden. Der Alterungszustand kann unter Verwenden des ersten Modells, der zweiten Vorgangsdaten und der zweiten realen Vorgangskapazität, durch Vergleichen der Lade-/Entladephasen unter Verwenden eines Modells zur Berechnung einer Vorgangskapazität eines Lade-/Entladevorgangs bestimmt werden. Ein Vergleichen kann beispielsweise im Allgemeinen ein Bestimmen einer Differenz zwischen einem ersten und einem zweiten Wert, oder eines Anteils, z.B. eines Prozentwerts, basierend auf dem ersten und dem zweiten Wert, umfassen. In anderen Beispielen kann ein Bestimmen eines Alterungszustandes ein Bestimmen eines Alterungszustands basierend auf einer linearen oder nicht-linearen Zuordnungsfunktion zwischen einer Differenz bzw. Verhältnis eines oder mehrerer vorbestimmter Parameter oder Vorgangskapazitäten und einem Alterungszustand umfassen.

Zusammenfassend wird im Allgemeinen wird ein Alterungszustand bestimmt, indem basierend auf den beschriebenen Techniken ein Unterschied bzw. eine Veränderung zwischen einem ersten Alterungszustand und einem zweiten Alterungszustand bestimmt wird. Der Unterschied kann relativ als Verhältnis (Prozentwert) bestimmt werden, oder kann als absoluter Wert (als Differenz zwischen zwei Parametern oder Vorgangskapazitäten bestimmt werden, und gibt somit eine Alterung oder Veränderung zwischen zwei Alterungszuständen wieder.

Es ist auch denkbar, dass eins der aufgebauten Modelle einem initialen bekannten Alterungszustand entspricht, beispielsweise einem neuem Zustand, beispielsweise ohne durchgeführte Lade-/Entladevorgänge, oder einem beliebigen bekannten Alterungszustand. Somit kann, wenn der erste oder zweite Alterungszustand absolut bekannt ist, der andere von dem ersten und zweiten Alterungszustand bestimmt werden.

Insbesondere kann ein Bestimmen des Alterungszustands die folgenden Techniken, oder Kombination von Techniken, umfassen, die im Folgenden detaillierter beschrieben werden:

A) Anwenden des ersten Modells, welches einem ersten Alterungszustand entspricht, auf einen zweiten realen Lade-/Entladevorgang, für welchen Messdaten vorliegen und welcher einem zweiten Alterungszustand entspricht. Dabei kann das erste Modell zunächst basierend auf dem ersten Vorgang erstellt und validiert werden, danach kann optional eine simulierte Kapazität des ersten Vorgangs mit dem Modell der ersten Vorgangsdaten durchgeführt werden. Danach kann das Modell auf Vorgangsdaten eines zweiten Lade-/Entladevorgangs angewendet werden, welcher einem zweiten veränderten Alterungszustand entspricht, und durch Vergleichen der simulierten Vorgangskapazität und der realen gemessenen Vorgangskapazität des zweiten Lade-/Entladevorgangs, kann bei zunehmender Alterung ein zunehmender Modellfehler bestimmt werden.

B) Bestimmen eines zweiten Modells für den zweiten Lade-/Entladevorgang, welche einem zweiten Alterungszustand entsprechen, und Anwenden des ersten Modells und des zweiten Modells auf einen beliebigen, beispielweise hypothetischen, realen, oder nicht realen, Lade-/Entladevorgang, d.h. auf beliebige Vorgangsdaten, sowie Vergleichen der simulierten Vorgangskapazitäten für den beliebigen Lade-/Entladevorgang basierend auf dem ersten und dem zweiten Modells, wobei bei zunehmender Alterung eine zunehmende Abweichungen zwischen den Modellergebnissen des ersten und des zweiten Modells bestimmt wird. Beispielsweise können Sie erste und das zweite Modell auf einen vollständigen Lade-/Entladevorgang angewendet werden, oder einen oder mehrere vollständigen Lade-/Ladezyklen.

Beispielsweise das erste und das zweite Modell statt auf einen beliebigen Vorgang auch auf den ersten oder den zweiten realen Lage-/Entladevorgang angewendet werden.

Beispielsweise können das erste und das zweite Modell auch direkt verglichen werden durch ein Vergleichen von Modellparametern des ersten Modells und des zweiten Modells, wobei bei zunehmender Alterung eine zunehmende Abweichung zwischen sich entsprechenden Modellparametern bestimmt wird.

C) Reparametrisieren des ersten Modells anhand der ersten und der zweiten Vorgangsdaten, um ein zweites Modell zu bestimmen, Anwenden des ersten Modells auf den ersten Ladevorgang, Anwenden des zweiten Modells auf den ersten und den zweiten Ladevorgang, und Vergleichen der Modellfehler des ersten und des zweiten Modells, wobei bei zunehmender Alterung ein zunehmender Modellfehler bestimmt wird.

D) Für einen Energiespeicher kann ein initialer Alterungszustand bekannt sein. Dieser initiale Alterungszustand an beispielsweise einem neuen Zustand direkt nach der Produktion entsprechen, und kann daher beispielsweise durch Ausgangstests am Ende einer Produktion bestimmt sein, oder durch eine technische Spezifikation beispielsweise einem Datenblatt des Energiespeichers bestimmt sein.

Durch einen Gebrauch des Energiespeichers, d.h. eine Vielzahl von Lade und Ladezyklen, kann der Energiespeicher altern und somit kann der mindestens eine erste Lade-/Entladevorgang einem ersten Alterungszustand nach einer Vielzahl von vorherigen Lade-/Entladevorgängen entsprechen. Beispielsweise können nach einer Auslieferung eines Energiespeichers für einen bestimmten Zeitraum, d.h. für eine Vielzahl von Lade-/Entladevorgängen keine Daten vorliegen, und danach können Vorgangsdaten und Vorgangskapazitäten für einen oder mehrere Lade-/Entladevorgänge vorliegen, welche einem gealterten Zustand entsprechen.

In diesem Fall kann ein Modell basierend auf dem mindestens einen Lade-/Entladevorgang, vorzugsweise einer Vielzahl von Lade-/Entladevorgängen etwa einer ersten Teilmenge von Lade-/Entladevorgängen, welche dem gealterten Alterungszustand entsprechen, aufgebaut und validiert werden.

Der Alterungszustand kann bestimmt werden, indem mittels des Modells eine simulierte Ladekapazität basierend auf Vorgangsdaten berechnet wird, und diese mit einer Ladekapazität verglichen wird, die sich aus dem initialen bekannten Zustands ergeben. Beispielsweise können die Vorgangsdaten und Vorgangskapazität einem Lade-/Entladeprotokoll Energiespeichers entsprechen, die einem bekannten, insbesondere neuwertigen, Zustand Energiespeichers, z.B. einer Konfiguration eines Speichers oder Speichersystems, entsprechen.

In einem Beispiel kann mittels des Modells ein beliebiger Ladevorgang, vorzugsweise ein Vollzyklus, simuliert werden. Der Alterungszustand kann damit anhand der initialen bekannten Gesamtkapazität des Energiespeichers berechnet werden.

Es ist denkbar, dass Parameter des ersten und/oder zweiten Modells basierend auf Vorgangsdaten/Vorgangskapazitäten entsprechend einem absolut bekannten (z.B. initialen) Alterungszustand angepasst/trainiert werden, d.h. parametriert werden, um ein initiales Modell für den Energiespeicher zu erzeugen.

In diesem Fall wäre es denkbar, dass das Gerät anstelle von zweiten Vorgangsdaten und einer zweiten Vorgangskapazität ein vorbestimmtes initiales Modell umfasst, d.h. speichert oder erhält.

Somit kann durch Vergleich von einem oder mehrerer Parameter des initialen Modells und des ersten bzw. zweiten Modells ein Alterungszustand absolut bestimmt werden. Beispielsweise kann auch ein beliebiger Lade-/Entladevorgang basierend auf dem initialen Modell und einem Modell, das einem gealterten Zustand des Energiespeichers entspricht simuliert werden, und die Simulationsergebnisse verglichen werden. Beispielsweise kann ein beliebiger realer Lade-/Entladevorgang mit dem initialen Modell simuliert werden und das simulierte Ergebnis mit der realen Vorgangskapazität verglichen werden, um einen Alterungszustand zu bestimmen.

Die offenbarten Techniken ermöglichen dadurch eine erhöhte Genauigkeit, insbesondere eine genaue Kapazitätsbestimmung und somit SOH Abschätzung, gerade bei gealterten Zellen, wohingegen Verfahren wie die Ladungsdurchsatzbestimmung (engl. Ah-Counting, dt. Coulomb-Zähler) oder Kalman Filter über die Lebensdauer immer ungenauere Kapazitätswerte liefern. Weiter wird für den Modellaufbau und das Simulieren weniger Zeit benötigt, als für das Parametrieren anderer Modelle wie z.B. Kalman Filter, die lange angepasst und getuned werden müssen. Auch werden die erfindungsgemäßen Techniken keine Wartungszyklen benötigt, sondern vorhandene Vorgangsdaten aus unterschiedlichen Lade-/Entladephasen verwendet. Nachdem keine Wartungszyklen gefahren werden müssen ergibt sich zudem eine Kostenersparnis. Eine genaue Kapazitätsbestimmung lässt die Wirtschaftlichkeit von Batterien besser bewerten und durch den Betrieb beeinflussen.

Somit ist eine Kapazitäts- und somit State of Health-Bestimmung in realen und dynamischen Anwendungen bei regelmäßigen jedoch nicht direkt vergleichbaren Lade-/Entladephasen möglich, wobei ein Modell (bzw. mehrere Modelle) einen Vergleich von unterschiedlichen Lade-/Entladephasen bereitstellt. Die offenbarten Techniken sind für alle regelmäßig geladenen Batterien, wie beispielsweise Elektrofahrzeuge, stationäre Energiespeichersysteme, Power Tools, Smartphones, anwendbar.

Es ist zu verstehen, dass Merkmale die in einem der genannten Beispiele beschrieben sind, auf andere Beispiele übertragbar sind, sofern nicht gegenteilig beschrieben.

**In** diesem Zusammenhang können die beschriebenen Verfahren, wie unter den Gruppen A)-D) zusammengefasst, alternative Lösungen für die der Erfindung zugrundeliegende Aufgabe, die als Gemeinsamkeit aufweisen, dass aus Felddaten des Energiespeichers ein erstes Ladekapazitätsmodell bestimmt wird, und dieses Modell, sowie weitere Daten zumindest eines weiteren (zweiten) Lade-/Entladevorgangs verwendet werden, um eine Alterung / einen Alterungszustand zu bestimmen.

Das Gerät kann konfiguriert sein, einen Alterungszustand des Energiespeichers zu bestimmen, umfassend:

- Anwenden des ersten Modells auf die zweiten Daten, um eine simulierte Vorgangskapazität basierend auf den zweiten Vorgangsdaten und dem ersten Modell zu berechnen, und
- Bestimmen eines Alterungszustandes des Energiespeichers durch ein Vergleichen der zweiten realen Vorgangskapazität und der simulierten Vorgangskapazität basierend auf den zweiten Vorgangsdaten und dem ersten Modell.

Das Gerät kann konfiguriert sein, einen Alterungszustand des Energiespeichers zu bestimmen, umfassend:

- Anwenden des ersten Modells auf die ersten Daten, um eine simulierte Vorgangskapazität basierend auf den ersten Vorgangsdaten und dem ersten Modell zu berechnen,
- Bestimmen eines Modellfehlers des ersten Modells, welcher eine Differenz zwischen der ersten realen Vorgangskapazität und der simulierten Vorgangskapazität basierend auf dem ersten Lade-/Entladevorgang und dem ersten Modell umfasst,

- Erzeugen eines zweiten Modells basierend auf beiden Lade-/Entladevorgängen, d.h. basierend auf den ersten Vorgangsdaten und der ersten realen Vorgangskapazität sowie den zweiten Vorgangsdaten und der zweiten realen Vorgangskapazität,
- Anwenden des zweiten Modells auf die ersten Daten, um eine simulierte Vorgangskapazität basierend auf den ersten Vorgangsdaten und dem zweiten Modell zu berechnen,
- Anwenden des zweiten Modells auf die zweiten Vorgangsdaten um eine simulierte Vorgangskapazität basierend auf den zweiten Vorgangsdaten und dem zweiten Modell zu berechnen,
- Bestimmen eines Modellfehlers des zweiten Modells, welcher eine Differenz zwischen der ersten realen Vorgangskapazität und der simulierten Vorgangskapazität basierend auf den ersten Vorgangsdaten und dem zweiten Modell sowie eine Differenz zwischen der zweiten realen Vorgangskapazität und der simulierten Vorgangskapazität basierend auf den zweiten Vorgangsdaten und dem zweiten Modell umfasst, und
- Bestimmen einer Alterung des Energiespeichers durch Vergleichen des ersten und des zweiten Modellfehlers.

Hier wäre beispielsweise auch vorstellbar, das zweite Modell basierend auf beiden Lade-/Entladevorgängen auf die ersten Vorgangsdaten anzuwenden, und eine Alterung basierend auf einer Differenz zwischen der simulierten Vorgangskapazität basierend auf den ersten Vorgangsdaten und dem ersten Modell und der simulierten Vorgangskapazität basierend auf den ersten Vorgangsdaten und dem zweiten Modell zu berechnen.

Das Erzeugen eines zweiten Modells kann in einigen Beispielen ein Anpassen des ersten Modells basierend auf den zweiten Vorgangsdaten und der zweiten realen Vorgangskapazität, in anderen Worten ein Reparametrisieren des ersten Modells, umfassen, um das zweite Modell zu erzeugen.

Das Gerät kann konfiguriert sein, einen Alterungszustand des Energiespeichers zu bestimmen, umfassend:

- Erzeugen eines zweiten Modells für den mindestens einen zweiten Lade-/Entladevorgang, wobei durch Anwenden des zweiten Modells auf die zweiten Vorgangsdaten eine simulierte Vorgangskapazität des zweiten Lade-/Entladevorgangs basierend auf dem zweiten Vorgangsdaten und zweiten Modell berechnet wird, und
- Vergleichen von Modellparametern des ersten Modells mit Modellparametern des zweiten Modells, um eine Alterung des Energiespeicher zu bestimmen.

Das Gerät kann konfiguriert sein, einen Alterungszustand des Energiespeichers zu bestimmen, umfassend:

- Erzeugen eines zweiten Modells für den mindestens einen zweiten Lade-/Entladevorgang, wobei durch Anwenden des zweiten Modells auf die zweiten Vorgangsdaten eine simulierte Vorgangskapazität des zweiten Lade-/Entladevorgangs basierend auf dem zweiten Vorgangsdaten und zweiten Modell berechnet wird,
- Anwenden des ersten Modells auf Vorgangsdaten eines beliebigen Lade-/Entladevorgangs, um eine simulierte Vorgangskapazität für den beliebigen Lade-/Entladevorgang basierend auf dem ersten Modell zu berechnen,
- Anwenden des zweiten Modells auf die Vorgangsdaten des beliebigen Lade-/Entladevorgangs, um eine simulierte Vorgangskapazität für den beliebigen Lade-/Entladevorgang basierend auf dem zweiten Modell zu berechnen, und
- Bestimmen eines Alterungszustandes des Energiespeichers durch Vergleichen der simulierten Vorgangskapazität für den beliebigen Lade-/Entladevorgang basierend auf dem ersten Modell und der simulierten Vorgangskapazität für den beliebigen Lade-/Entladevorgang basierend auf dem zweiten Modell.

Ein Modell zur Bestimmung einer Vorgangskapazität eines Lade-/Entladevorgangs kann eins der folgenden Modelle umfassen:

- ein Regressionsmodell basierend auf einer Regressionsanalyse, welches unter Verwenden von Parametern eines Lade-/Entladevorgangs eines Energiespeichers eine simulierte Vorgangskapazität des Lade-/Entladevorgangs berechnet;
- ein Machine-Learning-Modell, welches basierend auf Messdaten und/oder Parametern eines Lade-/Entladevorgangs eines Energiespeichers als Eingabe, eine simulierte Vorgangskapazität des Lade-/Entladevorgangs als Ausgabe berechnet;
- ein empirisches Modell;
- ein Black Box Modell; und
- ein physikalisches Modell.

Beispielsweise kann ein erstes Modell, welches sich auf eine erste Teilmenge von Lade-/Entladevorgängen beziehen kann, ein Regressionsmodell sein. Vorgangsdaten, d.h. Vorgangsdaten für ein Regressionsmodell können die Parameter eines Lade-/Entladevorgangs umfassen.

Beispielsweise kann ein zweites Modell, welches sich auf eine zweite Teilmenge von Lade-/Entladevorgängen, oder auf die erste Teilmenge und die zweite Teilmenge von Lade-/Entladevorgängen, beziehen kann, ein Machine-Learning-Modell sein. Vorgangsdaten, d.h. Vorgangsdaten für ein Machine-Learning-Modell können die Messdaten von Lade-/Entladevorgängen und/oder Parameter von Lade-/Entladevorgängen sein. Ein Machine-Learning-Modell kann dabei insbesondere auch eine Spannung und eine Temperatur eines Lade-/Entladevorgangs verwenden.
Beispielsweise kann ein Modell zur Bestimmung einer Vorgangskapazität für einen Lade-/Entladevorgang ausgewählt werden basierend auf einer Fehlermetrik für die Ladevorgänge.
Beispielsweise kann, je mehr Daten vorliegen, ein Regressionsmodell einen höheren Fehler als ein Machine-Learning-Modell aufweisen, wobei ab einem vorbestimmten Schwellenwert für den Fehler von einem Regressionsmodell in ein Machine-Learning-Modell übergegangen wird. Beispielsweise kann ein Modell zur Bestimmung einer Vorgangskapazität basierend auf einer vorbestimmten Anzahl von Lade-/Entladevorgängen welche zur Erzeugung des Modells verfügbar sind, ausgewählt werden, d.h. von Lade-/Entladevorgängen in einer Teilmenge von Lade-/Entladevorgängen.
Es ist denkbar, dass das erste und das zweite Modell jeweils die gleiche Modellart aufweisen, d.h. ein Regressionsmodell oder ein Machine-Learning-Modell sind, oder dass das erste und das zweite Modell unterschiedliche Modellarten aufweisen, wobei eine beliebige Kombination möglich ist.
Es ist zu verstehen, dass die Techniken gemäß der vorliegenden Offenbarung nicht auf bestimmte Modellarten festgelegt sind, wobei ein beliebiges Modell verwendet werden kann, das geeignet ist aus Messdaten eines Lade-/Entladevorgangs eine Kapazität des Lade-/Entladevorgangs zu berechnen.
Ein Verfahren zum Bestimmen eines Alterungszustands eines Energiespeichers umfasst die folgenden Schritte:

- Erhalten von ersten Vorgangsdaten und einer ersten realen Vorgangskapazität mindestens eines ersten Lade-/Entladevorgangs des Energiespeichers;

- Erzeugen eines ersten Modells für den mindestens einen ersten Lade-/Entladevorgang des Energiespeichers, wobei durch Anwenden des ersten Modells auf die ersten Vorgangsdaten eine simulierte Vorgangskapazität des ersten Lade-/Entladevorgangs basierend auf den ersten Vorgangsdaten und dem ersten Modell berechnet wird;

- Umfassen einer zweiten Vorgangskapazität;

- Bestimmen eines Alterungszustandes des Energiespeichers unter Verwenden des ersten Modells und der zweiten Vorgangskapazität.

Ein Energiespeicher und ein Energiesystem sind konfiguriert, um ein beliebiges Verfahren oder eine beliebige Kombination von Verfahren gemäß der vorliegenden Offenbarung durchzuführen.
Das Gerät, der Energiespeicher oder das Energiesystem können einen Prozessor, einen Speicher und eine Schnittstelle umfassen, wobei der Speicher Befehle umfasst, die bei der Ausführung durch den Prozessor diesen veranlassen, die Schritte eines beliebigen Verfahrens gemäß der vorliegenden Offenbarung auszuführen.
Ein Computerprogramm umfasst Befehle, die bei der Ausführung des Programms durch einen Prozessor diesen veranlassen, die Schritte eines beliebigen Verfahrens gemäß der vorliegenden Offenbarung auszuführen.
Ein elektronisch lesbarer Datenträger umfasst Befehle, die bei der Ausführung durch einen Prozessor diesen veranlassen, die Schritte eines beliebigen Verfahrens gemäß der vorliegenden Offenbarung auszuführen. Zum Beispiel können die Daten und Befehle zur Ausführung des erfindungsgemäßen Verfahrens in einer verteilten Datenbank, insbesondere einer Cloud, gespeichert sein.
Für ein derartige Verfahren, Energiespeicher, Energiesysteme, Computerprogramme, Cloud-Lösungen und elektronisch lesbare Datenträger können technische Effekte erzielt werden, die den technischen Effekten für das Gerät gemäß der vorliegenden Offenbarung entsprechen.
Obwohl die in der obigen Zusammenfassung und der folgenden detaillierten Beschreibung beschriebenen Merkmale im Zusammenhang mit spezifischen Beispielen beschrieben werden, ist zu verstehen, dass die Merkmale nicht nur in den jeweiligen Kombinationen verwendet werden können, sondern auch isoliert oder in beliebigen Kombinationen verwendet werden können, und Merkmale aus verschiedenen Beispielen für Geräte, Verfahren, Energiespeicher, und Energiesysteme, miteinander kombiniert werden können und miteinander korrelieren, sofern nicht ausdrücklich anders angegeben.
Die obige Zusammenfassung soll daher nur einen kurzen Überblick über einige Merkmale einiger Ausführungsformen und Implementierungen geben und ist nicht als Einschränkung zu verstehen. Andere Ausführungsformen können andere als die oben beschriebenen Merkmale umfassen.

Kurze Beschreibung der Zeichnungen

Die Erfindung wird nachfolgend anhand bevorzugter Ausführungsbeispiele mit Bezug auf die beiliegenden Zeichnungen näher erläutert.

Dabei bezeichnen in den Figuren gleiche Bezugszeichen gleiche oder ähnliche Elemente. Die Figuren sind schematische Darstellungen verschiedener Ausführungsbeispiele der Erfindung, wobei die in den Figuren dargestellten Elemente nicht notwendigerweise maßstabsgetreu dargestellt sind. Vielmehr sind die verschiedenen in den Figuren dargestellten Elemente derart wiedergegeben, dass ihre Funktion und genereller Zweck für den Fachmann verständlich wird.

Figur 1 zeigt schematisch eine Vielzahl von Ladevorgängen eines Energiespeichers, gemäß Ausführungsbeispielen der Erfindung.

Figur 2 zeigt schematisch die akkumulierten Ladungsdurchsätze einer Vielzahl von Ladevorgängen eines Energiespeichers, gemäß Ausführungsbeispielen der Erfindung.

Figur 3 zeigt schematisch die Messkurven von Strom und Spannung eines Lade-/Entladevorgangs eines Energiespeichers, gemäß Ausführungsbeispielen der Erfindung.

Figur 4 zeigt eine beispielhafte Regressionsanalyse zum Bestimmen einer Kapazität des Energiespeichers aus Parametern des Lade-/Entladevorgangs der Figur 3.

Figur 5 zeigt ein Flussdiagramm mit Schritten zum Bestimmen eines Alterungszustandes eines Energiespeichers, gemäß Ausführungsbeispielen der Erfindung.

Figur 6 zeigt schematisch ein Gerät, welches zum Bestimmen eines Alterungszustandes eines Energiespeichers mittels eines erfindungsgemäßen Verfahrens konfiguriert ist.

Detaillierte Beschreibung

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, welche im Zusammenhang mit den Figuren näher erläutert werden.

Die Zeichnungen sind als schematische Darstellungen zu betrachten und die in den Zeichnungen dargestellten Elemente sind nicht unbedingt maßstabsgetreu dargestellt. Vielmehr werden die verschiedenen Elemente so dargestellt, dass ihre Funktion und ihr allgemeiner Zweck für einen Fachmann ersichtlich werden.

Dabei ist zu beachten, dass die Beschreibung der Ausführungsbeispiele nicht im in einem beschränkenden Sinne zu verstehen ist. Der Umfang der Erfindung soll nicht durch die im Folgenden beschriebenen Ausführungsbeispiele oder durch die Figuren eingeschränkt werden, welche nur zur Veranschaulichung dienen.

Nachfolgend werden verschiedene Techniken zum Bestimmen eines Alterungszustands eines Energiespeichers detaillierter Beschrieben.

Sofern es in der nachfolgenden Beschreibung nicht anders angegeben ist, beziehen sich die Begriffe durchführen, berechnen, rechnergestützt, rechnen, feststellen, generieren, konfigurieren, anpassen und dergleichen vorzugsweise auf Handlungen und/oder Prozesse und/oder Verarbeitungsschritte, die Vorgangsdaten verändern und/oder erzeugen und/oder die Vorgangsdaten in andere Vorgangsdaten überführen, wobei die Vorgangsdaten insbesondere als physikalische Größen dargestellt werden oder vorliegen können, beispielsweise als elektrische Impulse. Insbesondere sollten die Begriffe Computer, Steuergerät oder Gerät möglichst breit ausgelegt werden, um insbesondere alle elektronischen Geräte mit Datenverarbeitungseigenschaften abzudecken. Computer können somit beispielsweise Personal Computer, Server, speicherprogrammierbare Steuerungen (SPS), Handheld-Computer-Systeme, Pocket-PC-Geräte, IoT-Geräte Mobilfunkgeräte und andere Kommunikationsgeräte, die rechnergestützt Vorgangsdaten verarbeiten können, Prozessoren und andere elektronische Geräte zur Datenverarbeitung sein.

Unter rechnergestützt kann im Zusammenhang mit der Erfindung beispielsweise eine Implementierung des Verfahrens verstanden werden, bei dem insbesondere ein Prozessor mindestens einen Verfahrensschritt des Verfahrens ausführt.

Unter umfassen, insbesondere in Bezug auf Vorgangsdaten und/oder Messdaten und/oder Parameter, kann im Zusammenhang mit der Erfindung beispielsweise ein (rechnergestütztes) Speichern einer entsprechenden Information bzw. eines entsprechenden Datums in einer Datenstruktur/Datensatz (die z.B. wiederum in einer Speichereinheit gespeichert ist) verstanden werden.

Unter zuordnen, insbesondere in Bezug auf Vorgangsdaten und/oder Informationen, kann im Zusammenhang mit der Erfindung beispielsweise eine rechnergestützte Zuordnung von Vorgangsdaten und/oder Informationen verstanden werden.

Unter bereitstellen, insbesondere in Bezug auf Vorgangsdaten und/oder Informationen, kann im Zusammenhang mit der Erfindung beispielsweise ein rechnergestütztes Bereitstellen verstanden werden. Das Bereitstellen erfolgt beispielsweise über eine Schnittstelle (z.B. eine Datenbankschnittstelle, eine Netzwerkschnittstelle, eine Schnittstelle zu einer Speichereinheit). Über diese Schnittstelle können beispielsweise beim Bereitstellen entsprechende Vorgangsdaten und/oder Informationen übermittelt und/oder gesendet und/oder abgerufen und/oder empfangen werden.

Wiederaufladbare Batterien altern sowohl während der Lagerung (kalendarische Alterung) als auch während des Betriebs (zyklische Alterung). Eine Alterung kann eine Kapazitätsabnahme und/oder eine Zunahme der Impedanz bedeuten. Somit kann die Energie und Leistung der Batterie abnehmen, sodass sich beispielsweise für ein batteriebetriebenes Elektrofahrzeug die Reichweite verringert und das Beschleunigungsverhalten verschlechtert.

Folgende Aspekte, in anderen Worten Betriebskennwerte eines Energiespeichers, machen es notwendig einen Alterungszustand (engl. State of Health, SOH) - von Batterien im Allgemeinen, sowie insbesondere eine aktuelle Batteriekapazität und - impedanz im Speziellen zu kennen:

- Lebensdauerende - engl. End of Life (EOL) eines Energiespeichers - verbleibende Laufzeit und Reichweite einer durch den Energiespeicher betriebenen Anwendung bzw. eines Geräts
- Energie und Leistung einer Batterie bzw. eines Energiespeichers
- Lade- und Entladezeit sowie Lade- und Entladeleistung
- Kennwerte für ein Bestimmen einer Betriebssicherheit (z.B. Temperatur, Erhitzung, Thermal Runaway)
- Eintrittswahrscheinlichkeiten für einen sicherheitskritischen Ausfall bzw. Defekt des Energiespeichers
- Zuverlässigkeit und Ausfallwahrscheinlichkeit, Wahrscheinlichkeit für Eintreten eines (spontanen) Defekts bzw. einer Fehlfunktion des Energiespeichers (z.B. elektrisches Fliegen)
- Inhomogene Alterung eines Energiespeichers, Notwendigkeit oder Zeitpunkt eines Austauschs von Energiespeichermodulen, Reparaturbedarf
- Garantie, Anschlussgarantie, Gewährleistung bei gewerblicher Nutzung bzw. Verkauf
- Einflussgrößen der kalendarische Alterung, wie z.B. Ladezustand (engl. State of Charge, SOC) - und Temperatur
- Einflussgrößen der zyklischen Alterung wie z.B. SOC, Zyklentiefe oder Entladetiefe (engl. Depth of Discharge, DOD), Temperatur, sowie Lade- und Entladestrom
- Einflussgrößen verstärkter Alterung, z.B. hohe Ladeströme und niedrige Temperaturen verursachen den Alterungsmechanismus der Lithium Abscheidung - engl. Lithium Plating
- Vergleich gleicher Batterien (Typ) bei gleichen Einflussgrößen (Ausreißer)
- Vergleich verschiedener Batterien bei gleichen Einflussgrößen (Batteriequalität)
- Vergleich verschiedener Batterien bei verschiedenen Einflussgrößen (Einfluss unterschiedlicher Zellchemien, Formate, Vor- und Nachteile bzgl. der Einflussgrößen, z.B. Zelle A zeigt eine geringe Alterung bei Schnellladen, Zelle B zeigt eine stärkere Alterung bei niedrigeren Temperaturen)
- Restwertbestimmung, Wiederverkaufswert von Energiespeichern
- Alterungsvorhersage (-prädiktion) für Energiespeicher
- Analyse von Alterungsmechanismen von Energiespeicher

In anderen Worten, aus einem aktuellen Alterungszustand einer Batterie und/oder einer aktuellen Batteriekapazität und/oder einer aktuellen Batterieimpedanz, und/oder einer oder mehrerer in der Vergangenheit bestimmter Alterungszustände, und/oder Batteriekapazitäten und/oder Batterieimpedanzen, in anderen Worten aus einer Historie einer oder mehrerer der genannten Kenngrößen, oder aus einer beliebigen Kombination davon, kann bzw. können eine oder mehrere der folgenden Betriebskenngrößen eines Energiespeichers bzw. einer Anwendung eines Energiespeichers bestimmt werden.

Um den aktuellen SOH bestimmen zu können, benötigt man die aktuelle sowie die initiale (nominale) Batteriekapazität, bzw. die aktuelle sowie die initiale (nominale) Batterieimpedanz. Die aktuelle Batteriekapazität muss dabei exakt so gemessen werden wie die initiale Batteriekapazität, da sie wesentlich von der Anfangs- und Endspannung, dem Strom und -protokoll sowie der Umgebungstemperatur und Temperierung abhängen. In (Labor)messungen (für Publikationen) werden diese Randbedingungen mit festen Werten definiert, was allerdings in realen Anwendungen nicht der Fall ist.

Batterien werden in nahezu allen Anwendungen (z.B. Elektrofahrzeuge, stationäre Energiespeicher) regelmäßig und über einen Zeitraum von bis zu mehreren Stunden geladen. Die Entladung ist abhängig von der Anwendung, d. h. der Dynamik des Lastprofils.

Figur 1 zeigt schematisch eine Vielzahl von Ladevorgängen eines Energiespeichers, gemäß Ausführungsbeispielen der Erfindung.

Eine Vielzahl von einzelnen Ladevorgängen eines Energiespeichers ist entlang der horizontalen Zeitachse angeordnet. Für einen jeweiligen Lade-/Entladevorgang sind jeweils Parameter 103, insbesondere ein Strom, eine Spannung, und eine Temperatur, sowie jeweils ein gemessener Ladungsdurchsatz, d.h. eine reale Vorgangskapazität 101 abgebildet. Wie in Figur 1 zu sehen, unterscheiden sich die einzelnen Ladevorgänge in den Werten ihrer Parameter 103.

Figur 2 zeigt schematisch einen Verlauf von akkumulierten Ladungsdurchsätzen einer Vielzahl von Ladevorgängen eines Energiespeichers, gemäß Ausführungsbeispielen der Erfindung. Wie in Figur 2 zu sehen, unterscheiden sich die Ladevorgänge in ihrem zeitlichen Verlauf ihres akkumulierten Ladungsdurchsatzes.

Lade-/Entladephasen von Energiespeicher können sich in einem oder mehreren der folgenden Parameter voneinander unterscheiden:

- Spannung: Anfangs- und Endspannung
- Strom: maximaler Strom, Abschaltstrom
- Temperatur: Umgebungstemperatur, minimale und maximale Temperatur
- Ladezeit
- Vorgangskapazität
- Ladeprotokoll
    - Plugin Laden, (super) Schnellladen
    - Konstantstrom, Konstantspannung oder beides, Erhaltungsladen, Konstantleistung, Spannungsrampen

Beispielsweise können die offenbarten Techniken eine Teilmenge der Parameter verwenden, insbesondere eine Anfangsspannung, eine Endspannung, einen Mittelwert des Stroms in einer Konstantstrom-Ladephase, einen Abbruchstrom (Endstrom) und einen Temperaturwert. Optional kann ein Mittelwert eines Stroms in einer Konstantspannungs-Ladephase verwendet werden.

Dabei ist zu beachten, dass die Kapazität und somit der SOH einer Batterie in realen Anwendungen sich durch einen direkten Vergleich der Lade-/Entladephasen im allgemeinen nicht bestimmen lässt, da sich die Randbedingungen - u. a. Parameter wie beispielweise Spannungsfenster, Strom, Temperatur - bei jeder Ladephase unterscheiden können.

Die Kapazität und der SOH lassen sich beispielsweise durch eine oder eine Kombination der folgenden Techniken bestimmen.

- Durch den Vergleich gleicher Lade- oder Lade-/Entladephasen (z.B. durch Wartungszyklen)

Dabei müssen die (Wartungs-)Zyklen unter gleichen Bedingungen durchgeführt werden, was einen großen Aufwand bedeutet, z.B. Sicherstellen der gleichen (Umgebungs- bzw. Betriebs-) Temperatur des Energiespeichers, Laden oder Entladen des Energiespeichers auch wenn keine Energie zur Verfügung steht (Stichwort erneuerbare Energien) oder nachgefragt wird. Die Batterie wird dabei ohne wirtschaftliches oder technisches Interesse geladen oder entladen.

- Durch das Messen des Ladungsdurchsatz (Energiedurchsatz) während einer Ladephase

Dabei kann der SOH kann nicht ohne weiteres aus dem gesamten Ladungsdurchsatz (z.B. bestimmt durch einen Coulomb-Zähler) abgeleitet werden. Bei gleichem Ladungsdurchsatz kann der SOH sehr unterschiedlich sein, da Einflussgrößen wie Temperatur, SOC, Strom u. w. bei diesem Ansatz unberücksichtigt bleiben. Weiterhin funktioniert dieses Verfahren nur, wenn der gesamte Ladungsdurchsatz von Lebensdaueranfang bis Lebensdauerende aufgezeichnet wird. Sobald die Aufzeichnung unterbrochen wird, ist es unmöglich den richtigen SOH zu bestimmen oder eine Initialisierung mit dem anderweitig bestimmten Kapazitätswert wird notwendig.

- Durch die Verwendung von Modellen (z.B. Kalman Filter)

Dabei nutzen bisherige Modelle Strom-, Spannungs- und Temperaturdaten und simulieren die tatsächlichen Verläufe dieser Vorgangsdaten über die Zeit, wobei notwendig ist, dass die Modelle die Vorgangsdaten sehr gut abbilden, um eine Kapazitätsbestimmung überhaupt zu ermöglichen. Die Modelle sind oftmals für den Lebensdaueranfang parametriert und/oder parametrisiert und die Modellparameter werden nicht über die Lebensdauer angepasst, sodass diese über die Batterielebensdauer immer ungenauer werden.

Die offenbarten Techniken ermöglichen es die Lade-/Entladephasen, d.h. die Vorgangskapazität durch ein Modell zu vergleichen. Das Modell beabsichtigt nicht die Strom-, Spannungs- und Temperaturverläufe exakt nachzubilden, sondern die Vorgangskapazität anhand charakteristischer Parameter zu bestimmen. Somit werden die Lade-/Entladephasen vergleichbar und der SOH kann bestimmt werden.

Entsprechend der offenbarten Techniken werden Lade-/Entladephasen detektiert und charakteristische Parameter bestimmt.

Figur 3 zeigt schematisch die Messdaten 102,202 von Strom und Spannung eines Lade-/Entladevorgangs eines Energiespeichers, gemäß Ausführungsbeispielen der Erfindung.

Wie weiter in Figur 3 zu sehen, können die Parameter I_max, I_mean_CC, I_EOC, U_BOC, und U_EOC aus den Messwerten bestimmt werden. Beispielsweise können die Parameter auch in Abhängigkeit einer vorbestimmten Polarisation des Energiespeichers definiert sein, d.h. entsprechend einer vorbestimmten Polarisation des Energiespeichers.

Dabei werden Lade-/Entladephasen entweder durch einen Algorithmus über die Signale Strom, Spannung, Zeit und Ladungsdurchsatz (Strom integriert über die Zeit) detektiert oder es kann ein BMS Signal (charging active) genutzt werden, oder beides.

Aus einer oder mehreren Lade-/Entladephasen werden die Parameter durch einen Algorithmus z.B. aus den Signalen Strom, Spannung, Zeit und Temperatur bestimmt. Eine oder weitere die Ladung beeinflussende Größen (Betriebsparameter), wie beispielsweise Betrieb oder Ruhe vor der Ladung, Polarisation der Batterie vor der Ladung, sowie zusätzliches Batteriewissen (Batterieparameter), wie beispielsweise Zellchemie, Elektrodenbalancing, oder bisheriger Hauptalterungsmechanismus, können ebenfalls als Parameter ausgegeben werden und als Modellinput dienen.

Darauf aufbauend kann die Vorgangskapazität durch ein Modell, oder in anderen Worten eine oder mehrere trainierte Funktionen, oder eine Kombination davon simuliert werden.

Es kann ein Modell aufgebaut werden, das die Vorgangskapazität (Output) anhand der charakteristischen Parameter (Input, wie z.B. Anfangsspannung, Endspannung, maximaler Strom, Umgebungstemperatur) simulieren kann. Mithilfe des Modells lassen sich unterschiedliche Lade-/Entladephasen miteinander vergleichen.

Modelle können beispielsweise umfassen: Regressionsmodelle, empirische Modelle, Machine Learning Modelle, Black Box Modelle, physikalische Modelle, und weitere Modelle oder eine beliebige Kombination davon.

Eine gealterte Zelle weist bei gleichen Parametern eine geringere Vorgangskapazität auf. Einflüsse auf Parameter, die sich durch die Alterung ändern (z.B. höhere Temperatur durch höhere Impedanz) können im Modell besonders berücksichtigt werden.

Die Modellauswahl kann abhängig von den verfügbaren Parametern, der verfügbaren Datenmenge und/oder -vielfalt und der Modellkomplexität sein.

Im Allgemeinen weist ein komplexes Modell die höchste Genauigkeit auf. Als Voraussetzung muss jedoch eine gewisse Datenmenge mit hinreichender Vielfalt gegeben sein. Zusätzlich steigt mit der Modellkomplexität die benötigte Rechenleistung und -zeit. Da in der Praxis anfangs Vorgangsdaten begrenzt sind, wird zunächst ein vergleichbar einfaches Modell (z.B. Regressionsmodell) verwendet, das im weiteren Verlauf mit dem Zugewinn neuer Vorgangsdaten durch ein komplexeres Modell (z.B. neuronale Netze) ersetzt werden kann. Für den Übergang in ein komplexeres Modell ist der Vergleich von zuvor definierten Fehlermetriken maßgebend.

Regressions- und Machine Learning Modelle sind dazu in der Lage, auf Basis realer Felddaten die optimalen Modellparameter durch das Optimieren einer Verlustfunktion zu finden.

Figur 4 zeigt eine beispielhafte Regressionsanalyse zum Bestimmen einer Vorgangskapazität des Energiespeichers basierend auf den Parametern 103,203 des Lade-/Entladevorgangs der Figur 3.

In Figur 4 sind auf der horizontalen Achse die Ladevorgänge entsprechend ihrer Vorgangskapazität angeordnet.

Das Regressionsmodell in der Figur 4 lautet:

$$\begin{aligned} Ah_{ch} = a_1 \Delta \mathrm{UU_{BOC}} + a_2 \Delta \mathrm{UI_{EOC}} \\ + a_3 \sin(2\mathrm{U_{BOC}}) + a_4 \cos\left(\mathrm{T_{min,BOC}}\right) \\ + a_5 \sin(\mathrm{U_{BOC}}) + a_6 \cos\left(2\mathrm{T_{min,BOC}}\right) + a_7 \cos(2\mathrm{U_{BOC}}) + a_8 \sin(2\bar{\mathrm{I}}_{\mathrm{CC}}) \\ + a_9 \cos(\bar{\mathrm{I}}_{\mathrm{CC}}) \end{aligned}$$

Wie in Figur 4 zu sehen, sind für eine Vielzahl von Ladevorgängen die jeweiligen realen Vorgangskapazitäten $y_{hat}$, die simulierten Vorgangskapazitäten z, und die Residuen r, in anderen Werten Modellfehler, zwischen den gemessenen und simulierten Vorgangskapazitäten abgebildet.

Empirische und physikalische Modelle basieren in der Regel auf einer kleineren Datenmenge, die in Laboren gezielt erzeugt wurde. Durch das gezielte Einbringen von Expertenwissen können die optimalen Modellparameter gefunden werden.

Der SOH lässt sich nun bestimmen, da die Lade-/Entladephasen durch das Modell vergleichbar werden. Grundsätzlich können verschiedene Verfahren, oder eine beliebige Kombination davon, genutzt werden den SOH zu bestimmen, wie im Folgenden beschrieben wird.

Beispielsweise können sich die offenbarten Techniken entweder auf Ladevorgänge oder auf Entladevorgänge beziehen. Beispielsweise können alle Vorgänge des mindestens einen ersten und zweiten Vorgangs, und beliebige Teilmengen einer Vielzahl von Lade- und Entladevorgängen eines Energiespeichers, entweder nur Ladevorgänge, oder nur Entladevorgänge umfassen. Beispielsweise ist denkbar, die Techniken parallel für Lade- und Entladevorgänge anzuwenden, wobei für Lade- und Entladevorgänge jeweils eigene Messdaten und eigene Modelle verwendet werden können.

Es können neue Modelle aufgebaut und miteinander verglichen werden, z.B. nach bestimmen Zeitintervallen (1., 2., 3., 4.... Jahr), nach definierten Lade- oder Energiedurchsätzen (30000, 60000,... kWh), nach definierten Laufleistungen (100000, 200000,... km). Somit gibt es Modelle für unterschiedliche Alterungszustände. Zum einen können die sich ändernden Modellparameter verglichen werden oder zum anderen können gleiche Lade-/Entladephasen simuliert und miteinander verglichen werden. Zusätzlich kann die Ladephase einer gealterten Zelle im Modell einer ungealterten Zelle simuliert werden und der Kapazitätsverlust durch den Vergleich zwischen Modell und gemessenem Ladungsdurchsatz bestimmt werden.

Es kann ein Initialmodell mit neuen Vorgangsdaten regelmäßig reparametrisiert werden (d.h. Modellparameter werden unter Verwenden der neuen Vorgangsdaten angepasst) und der SOH durch den zunehmenden Modellfehler bestimmt.

Weiteres Expertenwissen kann bei der Modellerstellung einbezogen werden, z.B. Batteriewissen bei Aufbau eines Machine Learning Modells.

Die Algorithmen und Modelle können in einer Cloud oder einer verteilten Datenbank implementiert werden, wo gleichzeitig auch die Rohdaten/Messdaten, wie z.B. Strom, Spannung zentral gespeichert sein können.

Es kann ausreichen, lediglich die Parameter zu speichern. Dazu wird wesentlich weniger Speicherplatz benötigt als die Rohdaten dauerhaft zu speichern.

Ergebnisse eines oder mehrerer Modelle können der Initialisierung des Verfahrens zur Bestimmung des Ladungsdurchsatzes dienen.

Die Ergebnisse eines oder mehrerer Modelle können dazu verwendet werden, ein geändertes Ladeverhalten über die Batterielebensdauer, und/oder geänderten Betrieb und/oder Nutzung des Energiespeichers, Häufigkeit und Intensität des Ladens (z.B. Wiederverkauf eines Elektrofahrzeugs, andere Route eines Elektrobusses), ein Ladeprotokoll, zusätzlich nutzbare (freigeschaltete) Batteriekapazität, oder eine Kombination davon zu bestimmen.

Ein Modell kann außer einer Simulation einer Batteriekapazität z.B. auch eine Temperatur des Energiespeichers, wenn diese nicht mehr verfügbar ist (Sensorausfall) oder des Stroms, wenn Stromsensor nicht genau genug ist, bereitstellen.

Ein oder mehrere Modelle können auf Zell-, Modul-, Pack- und Systemlevel angewendet werden.

Ein Modell kann angewendet werden, wenn Batterien annähernd gleichbleibend entladen werden, z.B. USV Anlagen, die sich stets im Erhaltungsladen befinden und wiederkehrend (bei Stromausfall) (teil)entladen werden oder Inselnetze, die über konstante Verbraucher entladen werden.

Figur 5 zeigt ein Flussdiagramm mit Schritten zum Bestimmen eines Alterungszustandes eines Energiespeichers, gemäß Ausführungsbeispielen der Erfindung.

Das Verfahren umfasst die folgenden Schritte:

- T10 Beginn des Verfahrens
- T20 Erhalten von ersten Vorgangsdaten und einer ersten realen Vorgangskapazität mindestens eines ersten Lade-/Entladevorgangs des Energiespeichers;
- T30 Erzeugen ersten Modells für den mindestens einen ersten Lade-/Entladevorgang des Energiespeichers, wobei durch Anwenden des ersten Modells auf die ersten Vorgangsdaten eine simulierte Vorgangskapazität des ersten Lade-/Entladevorgangs basierend auf den ersten Vorgangsdaten und dem ersten Modell berechnet wird;
- T40 Erhalten von zweiten Vorgangsdaten und einer zweiten realen Vorgangskapazität mindestens eines zweiten Lade-/Entladevorgangs des Energiespeichers;
- T50 Bestimmen eines Alterungszustandes des Energiespeichers unter Verwenden des ersten Modells, der zweiten Vorgangsdaten und der zweiten realen Vorgangskapazität, und
- T60 Ende des Verfahrens.

Figur 6 zeigt schematisch ein Gerät 1, welches zum Bestimmen eines Alterungszustandes eines Energiespeichers mittels eines erfindungsgemäßen Verfahrens konfiguriert ist.

Das Gerät 10 umfasst eine Schnittstelle 20 zum Senden/Empfangen von Daten, einen Speicher 30, und einen Prozessor 40, wobei der Speicher 30 Befehle umfasst, die bei der Ausführung durch den Prozessor 40 diesen veranlassen, die Schritte eines beliebigen Verfahrens gemäß der vorliegenden Offenbarung auszuführen.

Unter einem Prozessor kann im Zusammenhang mit der Erfindung beispielsweise eine Maschine oder eine elektronische Schaltung verstanden werden. Bei einem Prozessor kann es sich insbesondere um einen Hauptprozessor (engl. Central Processing Unit, CPU), einen Mikroprozessor oder einen Mikrokontroller, beispielsweise eine anwendungsspezifische integrierte Schaltung oder einen digitalen Signalprozessor, möglicherweise in Kombination mit einer Speichereinheit zum Speichern von Programmbefehlen, etc. handeln. Bei einem Prozessor kann es sich beispielsweise auch um einen IC (integrierter Schaltkreis, engl. Integrated Circuit), insbesondere einen FPGA (engl. Field Programmable Gate Array) oder einen ASIC (anwendungsspezifische integrierte Schaltung, engl. Application-Specific Integrated Circuit), oder einen DSP (Digitaler Signalprozessor, engl. Digital Signal Processor) oder einen Grafikprozessor GPU (Graphic Processing Unit) handeln. Auch kann unter einem Prozessor ein virtualisierter Prozessor, eine virtuelle Maschine oder eine Soft-CPU verstanden werden. Es kann sich beispielsweise auch um einen programmierbaren Prozessor handeln, der mit Konfigurationsschritten zur Ausführung des genannten erfindungsgemäßen Verfahrens ausgerüstet wird oder mit Konfigurationsschritten derart konfiguriert ist, dass der programmierbare Prozessor die erfindungsgemäßen Merkmale des Verfahrens, der Komponente, der Module, oder anderer Aspekte und/oder Teilaspekte der Erfindung realisiert.

Unter einem Speicher, einer Speichereinheit oder Speichermodul und dergleichen kann im Zusammenhang mit der Erfindung beispielsweise ein flüchtiger Speicher in Form von Arbeitsspeicher (engl. Random-Access Memory, RAM) oder ein dauerhafter Speicher wie eine Festplatte oder ein Datenträger verstanden werden.

Im Allgemeinen sehen Beispiele der vorliegenden Offenbarung eine Vielzahl von Schaltungen, Datenspeichern, Schnittstellen oder elektrische Verarbeitungsvorrichtungen z.B. Prozessoren vor. Alle Verweise auf diese Einheiten und andere elektrische Geräte sowie die von ihnen bereitgestellte Funktionen sind nicht auf das beschränkt, was veranschaulicht und beschrieben wird. Während den verschiedenen Schaltkreisen oder anderen offenbarten elektrischen Geräten bestimmte Bezeichnungen zugeordnet werden können, sind diese Bezeichnungen nicht dazu bestimmt, den Funktionsumfang der Schaltkreise und der anderen elektrischen Geräte einzuschränken. Diese Schaltkreise und andere elektrische Geräte können je nach der gewünschten Art der elektrischen Ausführung miteinander kombiniert und/oder voneinander getrennt werden. Es ist zu verstehen, dass jede offenbarte Schaltung oder andere elektrische Vorrichtung eine beliebige Anzahl von Mikrocontrollern, Grafikprozessoreinheiten (GPU), integrierte Schaltungen, Speichervorrichtungen, z.B. FLASH, Arbeitsspeicher(RAM), Read Only Memory (ROM), elektrisch programmierbarer Read Only Memory (EPROM), elektrisch löschbarer programmierbarer Read Only Memory (EEPROM), oder beliebige andere geeignete Ausführungsformen derselben umfassen können, sowie Software, welche miteinander zusammenarbeiten, um die hierin offenbarten Verfahrensschritte durchzuführen. Darüber hinaus kann jede der elektrischen Vorrichtungen konfiguriert sein, um Programmcode auszuführen, der in einem elektronisch lesbaren Datenträger enthalten ist, und der konfiguriert ist, um eine beliebige Anzahl von Schritten gemäß der Verfahren der vorliegenden Offenbarung auszuführen.

Aus dem oben Gesagten lassen sich einige allgemeine Schlussfolgerungen ziehen:
Die offenbarten Techniken betreffen Speicher für elektrische Energie, oder in anderen Worten durch elektrische Energie (Strom) aufladbare Energiespeicher, elektrischer Energiespeicher, Batterien oder wiederaufladbare Batterien, insbesondere Lithium-Ionen-Batterien.

Nach Auslieferung eines Energiespeichers, d.h. ab Beginn eines Gebrauchs oder ab dem ersten Lade/Entladevorgang können im fortlaufenden Gebrauch Benutzungsdaten anfallen, die auch als Felddaten bezeichnet werden können. Somit können alle Vorgangsdaten und Vorgangskapazitäten, beispielsweise zum Aufbau von Modellen, Felddaten sein. Die beschriebenen Techniken können rein datenbasiert durchgeführt werden, d.h. einzig basierend auf Felddaten des Energiespeichers. Beispielsweise können die aufgebauten Modell nur auf Felddaten basieren, so dass ein Energiespeicher, nicht während der Fertigung vermessen, d.h. geladen und entladen werden muss, um ein Modell für eine Lade-/Entladekapazität, d.h. ein Kapazitätsmodel, aufzubauen. Beispielsweise können auf den Felddaten einzelne Gruppen oder Teilmengen von Lade-/Entladevorgängen ausgewählt werden, die einer bestimmten Alterungsbedingungen oder bestimmten Nutzungsprofilen entsprechen, und die zum Aufbauen von Modellen verwendet werden, so dass diese Alterungen genau bestimmt werden können.

Die offenbarten Techniken können sich eignen, einen aktuellen (d.h. zum aktuellen Zeitpunkt, oder zum Zeitpunkt einer Durchführung des Verfahrens vorliegenden) Alterungszustand, und insbesondere eine aktuelle Batteriekapazität und/oder aktuelle Batterieimpedanz zu bestimmen. Der Alterungszustand kann aus einem Vergleich mindestens eines ersten Lade-/Entladevorgangs und mindestens eines zweiten Lade-/Entladevorgangs bestimmt werden, wobei die Ladebedingungen, insbesondere eines oder mehrere von einer Anfangsspannung, einer Endspannung, einem Strom, einem Abbruchstrom und einer Temperatur, der verglichenen Ladevorgänge unterschiedlich sein können. Somit können Lade-/Entladephasen mit unterschiedlichen Ladebedingungen verglichen werden, um einen Alterungszustand des Energiespeichers zu bestimmen.

Die Parameter, die einen Lade-/Entladevorgang charakterisieren, und die Parameter, auf die ein Modell angewendet wird, können eine beliebige spezifische Teilmenge der folgenden Parameter umfassen, oder aus einer spezifischen Teilmenge der folgenden Parameter des Lade-/Entladevorgangs bestehen:

- eine Anfangsspannung,
- eine Endspannung,

- einen maximalen Strom,
- einen Abschaltstrom, d.h. Endstrom,
- eine minimale, gemittelte oder maximale Umgebungstemperatur des Energiespeichers,
- eine minimale, gemittelte oder maximale Betriebstemperatur (gemessen an einem Referenzpunkt des Energiespeichers) des Energiespeichers,
- eine Ladezeit, d.h. Dauer des Lade-/Entladevorgangs,
- eine Vorgangskapazität, und
- ein Ladeprotokoll des Lade-/Entladevorgangs, wie beispielsweise Plugin Laden, (super) Schnellladen, Konstantstrom, Konstantspannung, Erhaltungsladen, Konstantleistung, Spannungsrampen, oder eine Kombination davon,
- Ladekapazität in einer Konstantstrom-Ladephase und Ladekapazität in einer Konstantspannungs-Ladephase,
- Entladekapazität in einer Konstantstrom-Entladephase und Entladekapazität in einer Konstantspannungs-Entladephase,
- Entladekapazität in der dynamischen Entladephase und Ladekapazität in der Rekuperationsphase,
- Lade-/Entladeparameter unter Berücksichtigung der Polarisation der Batterie,
- einen Polarisationszustand des Energiespeichers, d.h. einen Polarisationsparameter, der repräsentiert, wie stark der Energiespeicher polarisiert ist,
- Lade-/Entladeparameter vor/während Polarisation der Batterie,
- Mittlerer Lade-/Entladestrom,
- Standardabweichung Lade-/Entladestrom,
- Gleichstromwiderstand,
- Wechselstromwiderstand,
- Lastkollektive von Strom, Spannung, Temperatur, Kapazität,
- Zyklen und Halbzyklen,
- Mittlere Temperatur,
- Maximale Temperatur,
- Mittelwerte von Lade-/Entladeparametern,
- Maximale und minimale Werte von Lade-/Entladeparametern,
- Differenzen aus maximalen und minimalen Werten (Delta Berechnung), und
- Gradienten von Lade-/Entladeparametern, z. B. dV/dQ, dV/dt, dV/dT, dT/dQ.

Die Parameter können somit auch einen Bezug einer beliebigen Kombination von Messgrößen zueinander beinhalten, beispielsweise ein Integrieren oder ein Differenzieren einer Messgröße über bzw. nach einer anderen Messgröße, oder einen einzelnen Kennwert einer solchen Kombination.

Ein Energiespeicher kann eine Speicherkapazität, oder in anderen Worten eine maximale Speicherkapazität, aufweisen, welche die zu einem initialen oder aktuellen Zeitpunkt vorliegende maximale Kapazität zur Speicherung von Energie des Energiespeichers beschreibt. Beispielsweise kann eine Batterie eine Batteriekapazität aufweisen. In anderen Worten die Speicherkapazität oder Batteriekapazität kann für eine maximale Energiespeicherungskapazität eines Energiespeichers stehen, d.h. die Energiemenge, die maximal zu einem Zeitpunkt von dem Energiespeicher bzw. der Batterie gespeichert werden kann. Die Speicherkapazität bzw. Batteriekapazität kann somit somit eine Differenz zwischen vollständig entleertem Energiespeicher, d.h. keine weitere Energie kann entnommen werden, und maximal möglicher Ladung des Energiespeichers zu einem bestimmten Zeitpunkt, oder in anderen Worten bei einem bestimmten Alterungszustand beschreiben.

Eine Vorgangskapazität und einer oder mehrere Parameter können sich einen einzelnen zeitlich begrenzten Lade-/Entladevorgang zum Laden eines Energiespeichers beziehen. Die Vorgangskapazität kann die Energiemenge beschreiben, die dem Energiespeicher durch den Lade-/Entladevorgang zugeführt wird. In anderen Worten, die Vorgangskapazität kann durch eine Integration des Stroms über die Ladezeit bestimmt, d.h. gemessen, werden. Die Vorgangskapazität kann die Differenz zwischen Anfang und Ende des Lade-/Entladevorgangs der in dem Energiespeicher gespeicherten (und entnehmbaren) Energiemenge beschreiben. In anderen Worten, ein Energiespeicher kann zu Beginn eines Lade-/Entladevorgangs eine anfängliche gespeicherte Energiemenge enthalten, die dem Energiespeicher beispielsweise während eines Lade-/Entladevorgangs entnommen werden kann. Während eines Lade-/Entladevorgangs kann dem Energiespeicher Energie zugeführt werden, beispielsweise in Form elektrischer Energie durch einen Strom bzw. einer Spannung. Nach dem Lade-/Entladevorgang, d.h. wenn der Lade-/Entladevorgang beendet worden ist, kann der Energiespeicher dem Lade-/Entladevorgang entsprechend eine erhöhte gespeicherte Energiemenge enthalten, welche dem Energiespeicher beispielsweise während eines Lade-/Entladevorgangs entnommen werden kann. Die Vorgangskapazität des Lade-/Entladevorgangs kann die Differenz zwischen der anfänglich gespeicherten Energiemenge, und der erhöhten gespeicherten Energiemenge sein.

Die Parameter des Lade-/Entladevorgangs können für den Lade-/Entladevorgang charakteristische Messwerte sein, beispielsweise ein oder mehrere charakteristische Stromwerte des Ladungsstroms, und/oder ein oder mehrere charakteristische Spannungswerte der Ladungsspannung, und/oder ein oder mehrere charakteristische Temperaturwerte einer Temperatur des Energiespeichers, während des Lade-/Entladevorgangs. Die Parameter können im Allgemeinen Kennwerte sein, welche die Messwerte charakterisieren.

In diesem Zusammenhang können die Parameter einzelne zeitlich nicht unmittelbar aufeinanderfolgende Werte von Strom, Spannung, und/oder Temperatur, während eines Lade-/Entladevorgangs, sein, die als charakteristische Messwerte aus den den rohen Messdaten ausgewählt wurden. Insbesondere können ein oder mehrere Parameter so ausgewählt sein, dass ein Energiespeicher bei gleichen Parametern, d.h. gleichen Werten der Parameter, eine geringere Vorgangskapazität aufweist. Im Gegensatz dazu kann aus den rohen Messwerten, insbesondere die Messkurve des Ladungsstroms, die Vorgangskapazität auch direkt durch Integration des Ladungsstroms über Zeit bestimmt werden. In einigen Beispielen können Parameter, die den Strom beschreiben oder einen Messwert des Stroms umfassen, in einer Anzahl kleiner 50, 10, oder 5, oder 3 von dem Modell verwendet sein, so dass ein direktes Berechnen des Ladungsstroms durch Akkumulation, oder Integration über Zeit nicht von dem Modell umfasst sein kann. Insbesondere kann das Modell die Spannung und/oder die Temperatur berücksichtigen, bzw. Spannungs- oder Temperaturparameter.

Ein Alterungszustand eines Energiespeichers kann eine verringerte maximale Energiespeicherkapazität im Vergleich zu der initialen maximalen Speicherkapazität (Nenn-Speicherkapazität), und/oder einer erhöhte Impedanz im Vergleich zur initialen Impedanz umfassen.

Einzelne Entladevorgänge können zu einem Entladevorgang zusammengefasst werden, wenn es keine Entladungen dazwischen gibt. Das Gleiche gilt für Ladephasen, wenn diese unterbrochen sind.

Die vorliegende Erfindung beruht auf der Erkenntnis, dass eine gealterte Zelle bei gleichen Parametern eine geringere Vorgangskapazität aufweist, in anderen Worten kann ein Modell zur Berechnung einer Vorgangskapazität alterungsspezifisch sein, d.h. von einem Alterungszustand des Energiespeichers abhängen. Zur Bestimmung eines Alterungszustandes des Energiespeichers können verschiedene Lade-/Entladephasen mit Hilfe eines oder mehrerer einer jeweiligen Ladephase zugeordneten Modells bzw. Modelle vergleichbar gemacht werden.

Ein Energiespeicher kann während seiner Lebensdauer vielfach beispielsweise unregelmäßig und unter unterschiedlichen Bedingungen geladen bzw. entladen werden, in anderen Worten ein Energiespeicher kann eine Vielzahl von zeitlich beliebig angeordneten Ladevorgängen und/oder Entladevorgängen und/oder Ruhephasen in einer beliebigen Reihenfolge aufweisen. Eine Alterung des Energiespeichers kann basierend auf (d.h. unter Verwenden von) Messwerten, insbesondere von Parametern, von mindestens einem zeitlich definierten und/oder abgeschlossenen Lade-/Entladevorgang des Energiespeichers bestimmt werden. Eine Alterung des Energiespeichers kann beispielsweise zwischen (mindestens) einem ersten Lade-/Entladevorgang und (mindestens) einem zweiten Lade-/Entladevorgang bestimmt werden.

In einigen Beispielen kann eine Alterung des Energiespeichers basierend auf einer Vielzahl von Lade-/Entladevorgängen während seines Einsatzes vor Ort, d.h. während des laufenden Betriebs /der Nutzung in einer Anwendung, bestimmt werden. Beispielsweise kann eine erste Teilmenge von Lade-/Entladevorgängen des Energiespeichers entsprechend einem Zeitraum, oder einer Nutzungsart, oder beispielsweise ab dem Zeitpunkt des ersten Lade-/Entladevorganges ausgewählt werden.

Die Vielzahl von Lade-/Entladevorgängen kann beispielsweise in eine erste Teilmenge von Lade-/Entladevorgängen, welche beispielsweise in einem ersten Zeitintervall durchgeführt wurden, unterteilt werden. Die Vielzahl von Lade-/Entladevorgängen kann beispielsweise in eine zweite Teilmenge von Lade-/Entladevorgängen, welche beispielsweise in einem zweiten Zeitintervall, d.h. Zeitraum innerhalb der Lebensdauer des Energiespeichers definiert durch eine Anfangszeit und eine Endzeit, durchgeführt wurden, unterteilt werden. Das erste Zeitintervall und das zweite Zeitintervall können unmittelbar aufeinanderfolgen, oder können sich zumindest teilweise überschneiden, oder können durch einen Zeitraum, in welchem keine Messwerte von Lade-/Entladevorgängen und/oder Lade-/Entladevorgängen vorliegen, voneinander getrennt sein. Beispielsweise kann die Vielzahl von Lade-/Entladevorgängen in Teilmengen umfassend eine vorbestimmte Anzahl von Lade-/Entladevorgängen unterteilt werden, d.h. in aufeinanderfolgende Gruppen mit fester, oder variabler Anzahl von Lade-/Entladevorgängen.

Es ist zu verstehen, dass die erste Teilmenge von Lade-/Entladevorgängen und/oder die zweite Teilmenge von Lade-/Entladevorgängen nach unterschiedlichen Kriterien ausgewählt werden können. Beispielsweise können die Ladevorgänge der ersten bzw. zweiten Teilmenge von Lade-/Entladevorgängen einem vorbestimmten Zeitintervall entsprechen, ein einem oder mehreren vorbestimmten Bereich von Ladungshüben liegen, einem vorbestimmten Alterungszustand entsprechen, einem vorbestimmten Ladeverhalten entsprechen, oder einer stufenweisen Kapazitätsverringerung (Alterung), gemäß einem vorbestimmten prozentualen Stufenwert, entsprechen.

Jeder Lade-/Entladevorgang der Vielzahl von Lade-/Entladevorgängen kann durch Messwerte, beispielsweise des Stroms, und/oder der Spannung, und/oder der Temperatur, und/oder durch Parameter, welche den Lade-/Entladevorgang bzw. die Messwerte charakterisieren, definiert, oder in anderen Worten beschrieben oder charakterisiert sein. Die Parameter eines jeweiligen Lade-/Entladevorgangs können den Parametern eines weiteren Lade-/Entladevorgangs paarweise entsprechen, in anderen Worten die sich paarweise entsprechenden Parameter können in gleicher Art und Weise aus den jeweiligen Messwerten eines Lade-/Entladevorgangs bestimmt sein. In anderen Worten, die Parameter zwischen unterschiedlichen Lade-/Entladevorgängen können sich paarweise entsprechen, oder zumindest teilweise paarweise entsprechen, wobei die Parameter unterschiedliche Werte aufweisen können. Durch die unterschiedlichen Werte der sich paarweisenden Parameter können Unterschiede zwischen einem ersten Lade-/Entladevorgang und einem zweiten Lade-/Entladevorgang charakterisiert sein.

Im allgemeinen kann ein erster Lade-/Entladevorgang einen ersten Satz von Parametern aufweisen, und ein zweiter Lade-/Entladevorgang einen zweiten Satz von Parametern aufweisen, wobei der erste Satz von Parametern zumindest teilweise unterschiedlich ist zu dem zweiten Satz von Parametern. In anderen Worten, die Parameter eines ersten Lade-/Entladevorgangs können teilweise oder vollständig unterschiedlich sein zu den Parameter eines zweiten Lade-/Entladevorgangs.

Für die erste Teilmenge von Lade-/Entladevorgängen kann unter Verwenden von Messwerten und/oder den Parametern der Ladevorgänge in der ersten Teilmenge von Lade-/Entladevorgängen, ein Modell bestimmt werden. Das Modell kann für die Ladevorgänge einen Zusammenhang zwischen den Messwerten und/oder Parametern des Lade-/Entladevorgangs und der Vorgangskapazität der Ladevorgänge definieren. In anderen Worten eine Eingabe in das Modell kann die Messwerte/Parameter umfassen, und eine Ausgabe des Modells kann die Vorgangskapazität des Lade-/Entladevorgangs umfassen.

In einigen Beispielen kann eine Eingabe in das Modell auch einen oder mehrere Betriebsparameter des Energiespeichers umfassen, welche einen Betrieb oder ein Entladen des Energiespeichers in dem ersten Zeitintervall charakterisieren, z.B. einen Betrieb/Entladen zwischen den Lade-/Entladevorgängen. Charakterisieren, und/oder einen oder mehrere Energiespeicherparameter, welche technische Eigenschaften des Energiespeichers umfassen können.

Basierend auf einem initialen Zustand des Energiespeichers kann eine Lade-/Entladekapazität bestimmt werden, die mit einem simulierten Ergebnis des Modells verglichen werden kann, um einen Alterungszustand zu bestimmen.

Für eine zweite Teilmenge von Ladungsvorgängen kann unter Verwenden von Messwerten und/oder den Parametern der Ladevorgänge in der zweiten Teilmenge, ein zweites Modell bestimmt werden. Das Modell kann für einen Lade-/Entladevorgang einen Zusammenhang zwischen den Messwerten und/oder Parametern des Lade-/Entladevorgangs und der Vorgangskapazität des Lade-/Entladevorgangs definieren. In anderen Worten eine Eingabe in das Modell kann die Messwerte/Parameter umfassen, und eine Ausgabe des Modells kann die Vorgangskapazität des Lade-/Entladevorgangs umfassen.

Die Lade-/Entladevorgänge, welche in der ersten bzw. der zweiten Teilmenge von der Vielzahl von Lade-/Entladevorgängen des Energiespeichers enthalten sind, können nach einem oder mehreren Kriterien ausgewählt sein.

In der ersten bzw. zweiten Teilmenge können sich entweder nur Ladevorgänge oder nur Entladevorgänge befinden.

In einigen Beispielen kann ein Modell für bestimmte Ladeverhalten aufgebaut werden. Somit kann eine Teilmenge von Lade-/Entladevorgängen so ausgewählt werden, dass die enthaltenen Lade-/Entladevorgänge einem vorbestimmten Nutzungsverhalten, oder einem vorbestimmten Ladeverhalten entsprechen. Beispielsweise kann eine Teilmenge von Lade-/Entladevorgängen nur Ladevorgänge von Ladezyklen mit einer Vorgangskapazität unter bzw. über einem vorbestimmten Schwellenwert, oder innerhalb eines bestimmten Vorgangskapazitätsbereichs, d.h. innerhalb einer Ober- und Untergrenze einer Vorgangskapazität, umfassen. Beispielsweise kann eine Teilmenge von Lade-/Entladevorgängen nur Ladevorgänge mit einem bestimmten Ladeprotokoll, z.B. Konstantstrom-Laden oder Konstantspannungs-Laden, oder Schnellladen, oder eine spezifische Kombination davon, umfassen.

In einigen Beispielen können basierend auf, d.h. unter Verwenden von Batterieparameter und/oder einem Nutzungsverhalten, d.h. von Betriebsparametern des Energiespeichers, ausgewählt werden, welche Parameter/Messdaten für einen Modellaufbau verwendet werden. In anderen Worten, basierend auf einem oder mehreren Batterieparametern oder Betriebsparametern können die Parameter/Messdaten bestimmt werden, auf die ein Modell angewendet wird.

Die Messdaten und/oder Parameter und/oder die Modelle können in einer Cloud oder im Allgemeinen einer Netzwerkapplikation gespeichert werden. Dadurch wird beispielsweise in Vergleichen von verschiedenen Typen von Energiespeichern oder verschiedenen Herstellern von Energiespeichern möglich.

Unter einer Netzwerkapplikation kann beispielsweise eine dezentral verteilte Datenbank, ein verteiltes Datenbanksystem, eine verteilte Datenbank, eine Peer-to-Peer Applikation, ein verteiltes Speicherverwaltungssystem, eine Blockkette (engl. Blockchain), ein Distributed Ledger, ein verteiltes Speichersystem, ein Distributed Ledger Technology (DLT) basiertes System (DLTS) , ein revisionssicheres Datenbanksystem, eine Cloud, ein Cloud-Service, eine Blockkette in einer Cloud oder eine Peer-to-Peer Datenbank verstanden werden. Beispielsweise kann eine Netzwerkapplikation (oder auch als Netzwerkapplikation bezeichnet) ein verteiltes Datenbanksystem sein, das z.B. mittels einer Blockkette oder einem Distributed Ledger realisiert ist. Auch können beispielsweise unterschiedliche Implementierungen einer Blockkette oder eines DLTS verwendet werden, wie z.B. eine Blockkette oder ein DLTS, die mittels eines Directed Acylic Graph (DAG), eines kryptographischen Puzzles, einem Hashgraph oder einer Kombination aus den genannten Implementierungsvarianten umgesetzt ist. Unter einem verteilten Datenbanksystem oder einer Netzwerkapplikation kann beispielsweise auch ein verteiltes Datenbanksystem oder eine Netzwerkapplikation verstanden werden, von dem/der zumindest ein Teil seiner Knoten und/oder Geräte und/oder Infrastruktur durch eine Cloud realisiert sind. Beispielsweise sind die entsprechenden Komponenten als Knoten/Geräte in der Cloud (z.B. als virtueller Knoten in einer virtuellen Maschine) realisiert. Dies kann beispielsweise mittels VM-Ware, Amazon Web Services oder Microsoft Azure erfolgen. Aufgrund der hohen Flexibilität der erläuterten Implementierungsvarianten, können insbesondere auch Teilaspekte der genannten Implementierungsvarianten miteinander kombiniert werden, indem z.B. ein Hashgraph als Blockkette verwendet wird, wobei die Blockkette selbst z.B. auch blocklos sein kann.

In anderen Worten der mindestens eine erste Lade-/Entladevorgang kann einem ersten Zeitpunkt oder Zeitintervall, und/oder bei einem ersten Alterungszustand, und/oder bei einem ersten Nutzungsverhalten zugeordnet werden. Der mindestens eine zweite Lade-/Entladevorgang kann zu einem zweiten Zeitpunkt oder Zeitintervall, und/oder bei einem zweiten Alterungszustand, und/oder bei einem zweiten Nutzungsverhalten zugeordnet werden.

Es ist zu verstehen, das unter mindestens einem Lade-/Entladevorgang Bespiele mit genau einem Lade-/Entladevorgang, aber auch Beispiele mit mehreren Lade-/Entladevorgängen umfasst sein sollen. Beispielsweise können die mehreren Ladevorgänge eine Teilmenge von einer Vielzahl von Lade-/Entladevorgängen des Energiespeichers sein. Dadurch kann ein Modell, das einen Alterungszustand, welcher der entsprechenden Teilmenge von Lade-/Entladevorgängen entspricht, präziser trainiert werden.

Das erste Modell kann eine erste Vorgangskapazität des ersten Lade-/Entladevorgangs berechnen oder bestimmen, in anderen Worten abschätzen.

Im Allgemeinen können Modelle und/oder Modellparameter und/oder Ergebnisse von Modellen nach vorbestimmten Zeitintervallen, und/oder nach vorbestimmten (definierten) Lade- oder Energiedurchsätzen, und/oder nach definierten Laufleistungen, im Allgemeinen von unterschiedlichen Alterungszuständen verwendet werden, um ein oder mehrere weitere Modelle, d.h. eines anderen Zeitintervalls, und/oder anderen Lade- oder Energiedurchsatzes, und/oder anderer Laufleistung, im Allgemeinen von einem anderen Alterungszustand, aufzubauen und/oder zu parametrisieren. In anderen Worten können die Modelle aufeinander aufbauen oder basieren, oder ein Modell durch die Verwendung eines anderen Modells verbessert werden.

Das Gerät kann beispielsweise ein Ladegerät zum Laden des Energiespeichers mittels elektrischer Energie, ein Steuergerät z.B. in einem Energiesystem zum Steuern eines Ladungsvorgangs eines Energiespeichers, oder ein in einen Energiespeicher integriertes Steuergerät sein. Über die Schnittstelle kann ein solches Gerät die Rohdaten, d.h. Messdaten, und/oder Parameter, eines Lade-/Entladevorgangs, oder einer Historie von Lade-/Entladevorgängen empfangen oder senden. In dem Speicher können beispielsweise die Rohdaten, d.h. Messdaten, und/oder Parameter, und/oder eine Historie dieser Vorgangsdaten und/oder Parameter von vergangenen Lade-/Entladevorgängen gespeichert sein.

Beispielsweise können die trainierten Funktionen Ende-zu-Ende trainierte Funktionen sein, die mit einer Vielzahl von Trainingsdatensätzen trainiert wurden. Ein Trainingsdatensatz kann Vorgangsdaten enthalten, die mit Referenzausgabedaten verknüpft sind, z.B. kann ein Vorgangsdatensatz Parameter umfassen, die einen bekannten Lade-/Entladevorgang charakterisieren und die mit einer bekannten Vorgangskapazität des Lade-/Entladevorgangs verknüpft sein können. Die Anwendung trainierter Funktionen kann von einem neuronalen Netz durchgeführt werden, das eine Vielzahl von Klassifizierungsfunktionen umfassen kann.

In verschiedenen Beispielen können die trainierten Funktionen einen oder mehrere bekannte Klassifizierer für maschinelles Lernen umfassen. Ohne Einschränkung können die trainierten Funktionen z.B. auf einer oder mehreren einer Support-Vektor-Maschine, einem Entscheidungsbaum und/oder einem Bayesschen Netzwerk, k-Mittel-Clustering, Q-Learning, genetischen Algorithmen und/oder Assoziationsregeln basieren. Ein neuronales Netz kann beispielsweise ein Deep Neural Network, ein Convolutional Neural Network oder ein Convolutional Deep Neural Network, ein Adversarial Network, ein Deep Adversarial Network und/oder ein generatives Adversarial Network oder eine modellbasierte maschinenlernende Netzwerkarchitektur sein.

Eine KI-Engine oder ein Rechenmodul in einem Ladegerät oder einem Energiespeicher kann konfiguriert sein um eines der beschriebenen Verfahren durchzuführen, und verwendet mindestens eine in der Technik bekannte maschinelle Lernfunktion oder Klassifizierer, wie z.B. SVM und/oder ein neuronales Netz. In verschiedenen Beispielen verwendet die KI-Engine eine Vielzahl von maschinellen Lernfunktionen, z.B. sieben oder mehr maschinelle Lernfunktionen in einer geschichteten Netzwerkarchitektur.

Zur Verarbeitung der Parameter können beispielsweise neuronale Netze und Support-Vektor-Maschinen eingesetzt werden. Zur Analyse der Sensordaten können beispielsweise Sequenzqualifizierungsalgorithmen wie LSTM eingesetzt werden. In Bezug auf das Bestimmen des SOH kann die Anwendung trainierter Funktionen auf Parameter und/oder Sensorrohdaten, d.h. Messdaten des Ladeprozesses, die Anwendung mindestens eines Klassifizierungsalgorithmus auf die Vorgangsdaten umfassen, bei dem es sich um einen Klassifizierer für maschinelles Lernen handeln kann. Die trainierten Funktionen können beispielsweise um maschinell trainierten Klassifizierer umfassen, die in mehreren Schichten in einem neuronalen Netz auf einen Datensatz angewendet werden.

Trainierte Funktionen können einen trainierbaren Algorithmus oder ein trainierbares Modell umfassen, das auf die Parameter und/oder auf die Messdaten angewendet werden kann. Beispielsweise können trainierte Funktionen eine Vielzahl von Modellparametern umfassen, die definieren, wie die trainierten Funktionen auf die Parameter und Messdaten angewendet werden, und wie ein Alterungszustand aus den Parametern und/oder Messdaten bestimmt wird. Dabei können auf der Grundlage der Anwendung des trainierten Modells auf die Parameter und/oder Messdaten die Modellparameter angepasst, korrigiert oder geändert werden, so dass das reparametrierte Modell, in anderen Worten trainierte Funktion, verwendet werden kann, um einen präziseren Alterungszustand zu bestimmen.

Ein Modell des Energiespeichers kann beispielsweise eine digitale Simulation des Energiespeichers umfassen, insbesondere einen Digitalen Zwilling des Energiespeichers und/oder eines Ladegeräts des Energiespeichers und/oder eines Energiesystems.

Beispielsweise ist vorstellbar, dass als Parameter auch zeitliche Abstände zwischen den Zeitpunkten zweier einzelnen Parametern, d.h. die Zeitpunkte der den Parametern entsprechenden Ladeereignissen, umfassen, wie beispielsweise eine Zeitdauer zwischen dem Erreichen des maximalen Stroms und dem Abbruchstrom etc.

Die Verfahren können vorzugsweise rechnergestützt, d.h. computerimplementiert, realisiert sein.

Die offenbarten Techniken können im Allgemeinen auf einen beliebigen elektrischen Energiespeicher anwendbar sein, jedoch ist zu verstehen, dass die Techniken auch auf einen beliebigen Energiespeicher mit beliebigem Strom anwendbar sein können, wobei eine Alterung des Energiespeichers über mehrere Lade- und Entladevorgänge eine Änderung einer Vorgangskapazität eines Ladungsvorgangs bei gleichbleibenden Parametern umfassen kann.

Ein Erzeugen eines Modells, in anderen Worten eines Modells zum Bestimmen einer Vorgangskapazität eines Ladungsvorgangs eines Energiespeichers unter Verwenden von Parametern und/oder Messwerten des Lade-/Entladevorgangs, kann folgende Schritte umfassen.

Ein Empfangen von Parametern und/oder Messwerten und einer bekannten Vorgangskapazität mindestens eines bekannten Lade-/Entladevorgangs des Energiespeichers, welche einem bekannten Alterungszustand des Energiespeichers zugeordnet sind.

Bei dem bekannten Lade-/Entladevorgang kann es sich beispielsweise um den mindestens einen ersten Lade-/Entladevorgang handeln. Bei dem mindestens einen ersten Lade-/Entladevorgang kann es sich in einigen Beispielen auch um eine Vielzahl von ersten Lade-/Entladevorgängen handeln, welche beispielsweise in einer ersten Teilmenge von Lade-/Entladevorgängen enthalten sein können. Bei dem mindestens einen bekannten Lade-/Entladevorgang kann es sich in einigen Beispielen auch um den mindestens einen zweiten Lade-/Entladevorgang handeln, oder um eine Vielzahl von zweiten Lade-/Entladevorgängen handeln welche beispielsweise in einer zweiten Teilmenge von Lade-/Entladevorgängen enthalten sein können.

Ein Anwenden eines trainierbaren Modells auf die Messwerte und/oder die Parameter des mindestens einen bekannten Lade-/Entladevorgangs, wobei für den bekannten Lade-/Entladevorgang ein simulierter Alterungszustand erzeugt wird.

Ein Bestimmen einer Differenz zwischen dem bekannten Alterungszustand und dem simulierten Alterungszustand, Trainieren der Funktion basierend auf der ermittelten Differenz, und Bereitstellen des trainierten Modells zum Bestimmen einer Vorgangskapazität eines Ladungsvorgangs.

Ein Modell kann auf einen Satz von Parametern angewendet werden, um eine Vorgangskapazität eines Lade-/Entladevorgangs eines Energiespeichers zu bestimmen. In anderen Worten, durch das Anwenden des Modells auf einen Satz Parameter wird ein Wert bestimmt, welcher einer Vorgangskapazität eines Lade-/Entladevorgangs entspricht. Das Bestimmen einer Vorgangskapazität eines Energiespeichers aus Messwerten und/oder Parametern eines Lade-/Entladevorgangs eines Energiespeichers kann folgendes umfassen.

Erhalten von Parametern eines Lade-/Entladevorgangs. Bestimmen einer Vorgangskapazität eines Lade-/Entladevorgangs des Energiespeichers durch Anwenden eines Modells auf die Parameter, welche unter Verwenden von Parametern bekannter Ladevorgänge und zugeordneten bekannten Alterungszuständen trainiert wurde.

Messwerte eines Lade-/Entladevorgangs können eines oder mehrere umfassen von Messwerten eines Stroms des Energiespeichers über Zeit, Messwerten einer Spannung des Energiespeichers über Zeit, und Messwerten einer Temperatur des Energiespeichers über Zeit, während des Lade-/Entladevorgangs des Energiespeichers.

Anwenden eines Modells kann ein Anwenden eines trainierten Modells für den Energiespeicher umfassen, insbesondere eines Regressionsmodells zur Berechnung einer Vorgangskapazität des Energiespeichers unter Verwenden der Parameter, d.h. direkt aus den Parametern, eines Lade-/Entladevorgangs.

Die Parameter können insbesondere eines oder mehrere, im Allgemeinen eine beliebige Kombination, umfassen von einer Anfangsspannung (U_BOC), einer Endspannung (U_EOC), einem maximalen Strom (I_max), einen durchschnittlichen Strom (I_mean_CC), einen Abschaltstrom (I_EOC), einer Umgebungstemperatur, einer minimalen Betriebstemperatur und einer maximalen Betriebstemperatur, während des Lade-/Entladevorgangs.

Das Bestimmen einer Vorgangskapazität des Energiespeichers (100) kann ein Anwenden von trainierten Funktionen auf die Parameter (300) und/oder die Messdaten (200) umfassen, insbesondere ein Anwenden mindestens eines Machine-Learning (ML)-Klassifizierungsalgorithmus auf die Parameter (300) und/oder die Messdaten (200) durch ein neuronales Netzwerk.

Ein Gerät zum Bestimmen eines Alterungszustands eines Energiespeichers ist konfiguriert zum Empfangen von ersten gemessenen Vorgangsdaten mindestens eines ersten Lade-/Entladevorgangs des Energiespeichers, Erzeugen eines ersten Modells für den mindestens einen ersten Lade-/Entladevorgang, das unter Verwenden der ersten Vorgangsdaten einen ersten simulierten Kennwert des ersten Lade-/Entladevorgangs berechnet, Empfangen von zweiten gemessenen Vorgangsdaten mindestens eines zweiten Lade-/Entladevorgangs, Anwenden des ersten Modells auf die zweiten Daten, um einen zweiten simulierten Kennwert des zweiten Lade-/Entladevorgangs zu berechnen, und Bestimmen eines Alterungszustandes des Energiespeichers durch Vergleichen des zweiten simulierten Kennwerts mit den zweiten gemessenen Daten.

Das Bestimmen eines Alterungszustandes des Energiespeichers kann ein Bestimmen einer aktuellen Ladungskapazität und/oder einer aktuellen Impedanz des Energiespeichers umfassen.

Ein Erzeugen eines Modells basierend auf einem oder mehreren Parametern und einer Vorgangskapazitäten mindestens eines Lade-/Entladevorgangs kann umfassen: Erzeugen eines Modells für den mindestens einen Lade-/Entladevorgang und Trainieren des Modells, welches als Vorgangsdaten die ersten Vorgangsdaten und als Ausgabe eine simulierte Vorgangskapazität aufweist, und trainieren des Modells basierend auf dem einen oder mehreren Parametern, der realen Vorgangskapazität und der simulierten Vorgangskapazität des mindestens einen Lade-/Entladevorgangs.

Zusammenfassend werden Techniken für ein Bestimmen eines Alterungszustands von Lithium-Ionen-Batterien basierend auf einer Vielzahl von Lade-/Entladevorgängen bereitgestellt.

Aus Messdaten einer ersten Teilmenge von Lade-/Entladevorgängen des Energiespeichers wird ein erstes Modell aufgebaut. Das erste Modell wird auf einen zweiten Lade-/Entladevorgang, oder auf eine zweite Teilmenge von Lade-/Entladevorgängen, angewendet, um einen Alterungszustand des Energiespeichers, welcher dem zweiten bzw. der zweiten Teilmenge von Lade-/Entladevorgängen entspricht, zu bestimmen.

Dadurch ist es insbesondere möglich, einen Alterungszustand eines Energiespeichers zu bestimmen, unterschiedliche Ladevorgänge, aus denen allein ein Alterungszustand nicht bestimmbar ist, mittels eines Modells, welches eine Vorgangskapazität eines Lade-/Entladevorgangs berechnet, miteinander zu vergleichen, und dadurch einen Alterungszustand zu bestimmen.

In einem Beispiel kann ein Gerät zum Bestimmen eines Alterungszustandes eines Energiespeichers, konfiguriert sein zum:

- Umfassen von Vorgangsdatensätzen und gemessenen Vorgangskapazitäten einer Vielzahl von Lade-/Entladevorgängen eines Energiespeichers, entsprechend einem ersten Alterungszustand des Energiespeichers;
- Erzeugen eines Modells basierend auf den Vorgangsdatensätzen und den gemessenen Vorgangskapazitäten entsprechend dem ersten Alterungszustand des Energiespeichers, wobei durch Anwenden des Modells auf einen Vorgangsdatensatz eine simulierte Vorgangskapazität berechnet wird, die der gemessenen Vorgangskapazität des entsprechenden Lade-/Entladevorgangs entspricht;
- Umfassen eines Vorgangsdatensatzes und einer gemessenen Vorgangskapazität des Energiespeichers mindestens eines zweiten Lade-/Entladevorgangs des Energiespeichers, entsprechend einem zweiten Alterungszustand des Energiespeichers;
- Bestimmen einer Alterung des Energiespeichers zwischen dem ersten und dem zweiten Alterungszustand unter Verwenden: des Modells entsprechend dem ersten Alterungszustand, und des Vorgangsdatensatzes und der gemessenen Vorgangskapazität entsprechend dem zweiten Alterungszustand.

In einem weiteren Beispiel könnte das Gerät ein initiales Modell zur Berechnung einer Lade-/Entladekapazität umfassen, welches einem bekannten Alterungszustand entspricht. Beispielsweise könnte das initiale Modell aus Daten oder Messungen bei einer Fertigung aufgebaut, bzw. trainiert werden. Somit könnte basierend auf einem beliebigen Lade-/Entladevorgang aus einem Feldbetrieb eine Alterung bestimmt werden, in dem basierend auf dem initialen Modell und den Vorgangsdaten eine simulierte Vorgangskapazität berechnet und mit der realen Vorgangskapazität verglichen wird.

Obwohl die Erfindung in Bezug auf bestimmte bevorzugte Ausführungsbeispiele gezeigt und beschrieben wurde, werden durch Fachleute nach dem Lesen und Verstehen der Beschreibung Äquivalente und Änderungen vorgenommen werden. Die vorliegende Erfindung umfasst alle derartigen Äquivalente und Änderungen und ist nur durch den Umfang der beiliegenden Ansprüche begrenzt.

## Patentansprüche

**1.** Gerät zum Bestimmen eines Alterungszustands eines Energiespeichers (10), konfiguriert zum:

- Umfassen von ersten Vorgangsdaten (100) und einer ersten Vorgangskapazität (101) mindestens eines ersten realen Lade-/Entladevorgangs des Energiespeichers (10);
- Erzeugen eines ersten Modells (110) basierend auf den ersten Vorgangsdaten (100) und der ersten Vorgangskapazität (101) für den mindestens einen ersten Lade-/Entladevorgang des Energiespeichers (10), wobei durch Anwenden des ersten Modells (110) auf die ersten Vorgangsdaten (100) eine simulierte Vorgangskapazität (120) des ersten Lade-/Entladevorgangs berechnet wird, die der ersten Vorgangskapazität (101) entspricht;
- Umfassen von zweiten Vorgangsdaten (200) und einer zweiten Vorgangskapazität (201) mindestens eines zweiten Lade-/Entladevorgangs des Energiespeichers (10);
- Bestimmen eines Alterungszustandes des Energiespeichers (10) unter Verwenden des ersten Modells (110), der zweiten Vorgangsdaten (200) und der zweiten Vorgangskapazität (201).

**2.** Gerät nach Anspruch 1, wobei die zweiten Vorgangsdaten (200) und die zweite Vorgangskapazität (201) einem bekannten Alterungszustand des Energiespeichers (10) entsprechen, insbesondere einem initialen ungealterten Zustand des Energiespeichers, und das Bestimmen eines Alterungszustands ein Vergleichen einer simulierten Vorgangskapazität (120) basierend auf dem ersten Modell (110) und den zweiten Vorgangsdaten (200) mit der zweiten Vorgangskapazität (201) umfasst.

**3.** Gerät nach Anspruch 1, wobei die zweiten Vorgangsdaten (200) und die zweite Vorgangskapazität (201) mindestens einem zweiten realen Lade-/Entladevorgangs des Energiespeichers (10) entsprechen, der insbesondere gegenüber dem mindestens einen ersten realen Lade-/Entladevorgang zeitlich später durchgeführt wird.

**4.** Gerät nach einem der vorhergehenden Ansprüche, wobei der mindestens eine erste Lade-/Entladevorgang durch einen ersten Satz von Parametern (103) gekennzeichnet ist, und der mindestens eine zweite Lade-/Entladevorgang durch einen zweiten Satz von Parametern (203) gekennzeichnet ist, und der erste und der zweite Satz von Parametern (103, 203) eine beliebige Kombination der folgenden Parameter des jeweiligen Lade-/Entladevorgangs umfassen:

- einer Anfangsspannung (U_BOC);
- einer Endspannung (U_EOC);
- einem maximalen Strom (I_max);
- einem durchschnittlichen Strom während einer Konstantstrom-Ladephase (I_mean_CC);
- einem durchschnittlichen Strom während einer Konstantspannungs-Ladephase (I_mean_CV);
- einer Zeitdauer ab Beginn des Lade-/Entladevorgangs an dem zwischen einer Konstantstrom-Ladephase und einer Konstantspannungs-Ladephase umgeschaltet wird
- einem Abschaltstrom (I_EOC),
- einer minimalen Temperatur des Energiespeichers (10),
- und einer maximalen Temperatur des Energiespeichers (10);
- Ladekapazität in einer Konstantstrom-Ladephase und Ladekapazität in einer Konstantspannungs-Ladephase;
- Entladekapazität in einer Konstantstrom-Entladephase und Entladekapazität in einer Konstantspannungs-Entladephase;
- Entladekapazität in der dynamischen Entladephase und Ladekapazität in der Rekuperationsphase;
- Lade-/Entladeparameter unter Berücksichtigung der Polarisation der Batterie;
- einen Polarisationszustand des Energiespeichers;
- Lade-/Entladeparameter vor/während Polarisation der Batterie;
- Mittlerer Lade-/Entladestrom;
- Standardabweichung Lade-/Entladestrom;
- Gleichstromwiderstand;
- Wechselstromwiderstand;
- Lastkollektive von Strom, Spannung, Temperatur, Kapazität,
- Zyklen und Halbzyklen;
- Mittlere Temperatur;
- Maximale Temperatur;
- Mittelwerte von Lade-/Entladeparametern;
- Maximale und minimale Werte von Lade-/Entladeparametern;
- Differenzen aus maximalen und minimalen Werten (Delta Berechnung); und
- Gradienten von Lade-/Entladeparametern, insbesondere dV/dQ, dV/dt, dV/dT, dT/dQ.

**5.** Gerät nach Anspruch 4, wobei der erste Satz von Parametern (103) dem zweiten Satz von Parametern (203) zumindest teilweise paarweise entspricht, und die Werte von sich entsprechenden Parametern (103, 203) zumindest teilweise unterschiedlich sind.

6. Gerät nach einem der Ansprüche 3 bis 5, wobei das Bestimmen eines Alterungszustandes des Energiespeichers (10) umfasst:

   - Anwenden des ersten Modells (110) auf die zweiten Vorgangsdaten (200), um eine simulierte Vorgangskapazität (220) basierend auf den zweiten Vorgangsdaten (200) und dem ersten Modell (110) zu berechnen; und
   - Bestimmen einer Alterung des Energiespeichers (10) durch Vergleichen der zweiten Vorgangskapazität (201) und der simulierten Vorgangskapazität (220) basierend auf den zweiten Vorgangsdaten (200) und dem ersten Modell (130).

7. Gerät nach einem der Ansprüche 3 bis 5, wobei das Bestimmen eines Alterungszustandes des Energiespeichers (10) umfasst:

   - Anwenden des ersten Modells (110) auf die ersten Vorgangsdaten (100), um eine simulierte Vorgangskapazität (120) basierend auf den ersten Vorgangsdaten (100) und dem ersten Modell (110) zu berechnen;
   - Bestimmen eines ersten Modellfehlers des ersten Modells (110), welcher eine Differenz zwischen der ersten Vorgangskapazität (101) und der simulierten Vorgangskapazität (120) basierend auf den ersten Parametern (103) und dem ersten Modell (110) umfasst;
   - Erzeugen eines zweiten Modells (210) basierend auf den ersten Vorgangsdaten (100) und der ersten Vorgangskapazität (101) sowie den zweiten Vorgangsdaten (200) und der zweiten Vorgangskapazität (202);
   - Anwenden des zweiten Modells (230) auf die ersten Vorgangsdaten (100), um eine simulierte Vorgangskapazität (240) basierend auf den ersten Vorgangsdaten (100) und dem zweiten Modell (210) zu berechnen;
   - Anwenden des zweiten Modells (210) auf die zweiten Daten, um eine simulierte Vorgangskapazität (240) basierend auf den zweiten Vorgangsdaten (200) und dem zweiten Modell (210) zu berechnen;
   - Bestimmen eines zweiten Modellfehlers des zweiten Modells (210), welcher eine Differenz zwischen der ersten Vorgangskapazität (101) und der simulierten Vorgangskapazität (120) basierend auf den ersten Vorgangsdaten und dem zweiten Modell (210) sowie eine Differenz zwischen der zweiten Vorgangskapazität (201) und der simulierten Vorgangskapazität (220) basierend auf den zweiten Vorgangsdaten (200) und dem zweiten Modell (210) umfasst;
   - Bestimmen eines Alterungszustandes des Energiespeichers (10) durch Vergleichen des ersten und des zweiten Modellfehlers.

8. Gerät nach Anspruch 7, wobei das Erzeugen eines zweiten Modells (210) umfasst:

   - Anpassen der Werte von Modellparametern des ersten Modells (110) unter Beibehalten der Modellparameter unter Verwenden der zweiten Vorgangsdaten (200) und der zweiten Vorgangskapazität (201), um das zweite Modell (210) zu erzeugen.

9. Gerät nach einem der Ansprüche 3 bis 5, wobei das Bestimmen eines Alterungszustandes des Energiespeichers (10) umfasst:

   - Erzeugen eines zweiten Modells (210) basierend auf den zweiten Vorgangsdaten (200) und der zweiten Vorgangskapazität (201) für den mindestens einen zweiten Lade-/Entladevorgang, wobei durch Anwenden des zweiten Modells (210) auf die zweiten Vorgangsdaten (200) eine simulierte Vorgangskapazität (220) des zweiten Lade-/Entladevorgangs basierend auf den zweiten Vorgangsdaten (200) und dem zweiten Modell (210) berechnet wird, die der zweiten Vorgangskapazität (201) entspricht; und
   - Vergleichen mindestens eines Modellparameters des ersten Modells (130) mit mindestens einem Modellparameter des zweiten Modells (230), um einen Alterungszustand des Energiespeichers (10) zu bestimmen.

10. Gerät nach einem der Ansprüche 3 bis 5, wobei das Bestimmen eines Alterungszustandes des Energiespeichers (10) umfasst:

   - Erzeugen eines zweiten Modells (210) basierend auf den zweiten Vorgangsdaten (200) und der zweiten Vorgangskapazität (201) für den mindestens einen zweiten Lade-/Entladevorgang, wobei durch Anwenden des zweiten Modells (210) auf die zweiten Vorgangsdaten (200) eine simulierte Vorgangskapazität (220) des zweiten Lade-/Entladevorgangs basierend auf den zweiten Vorgangsdaten (200) und dem zweiten Modell (210) berechnet wird, die der zweiten Vorgangskapazität (201) entspricht;

- Anwenden des ersten Modells (110) auf Vorgangsdaten eines beliebigen Lade-/Entladevorgangs, um eine simulierte Vorgangskapazität für den beliebigen Lade-/Entladevorgang basierend auf dem ersten Modell (110) zu berechnen;
- Anwenden des zweiten Modells (210) auf die Vorgangsdaten des beliebigen Lade-/Entladevorgangs, um eine simulierte Vorgangskapazität für den beliebigen Lade-/Entladevorgang basierend auf dem zweiten Modell (210) zu berechnen;
- Bestimmen eines Alterungszustandes des Energiespeichers (10) durch Vergleichen der simulierten Vorgangskapazität für den beliebigen Lade-/Entladevorgang basierend auf dem ersten Modell (110) und der simulierten Vorgangskapazität für den beliebigen Lade-/Entladevorgang basierend auf dem zweiten Modell (210).

**11.** Gerät nach einem der vorhergehenden Ansprüche, wobei das erste Modell und das zweite Modell eines der folgenden Modelle umfassen:

- ein Regressionsmodell basierend auf einer Regressionsanalyse, welches unter Verwenden von Parametern eines Lade-/Entladevorgangs eines Energiespeichers (10) eine simulierte Vorgangskapazität des Lade-/Entladevorgangs berechnet;
- ein Machine-Learning-Modell, welches basierend auf Messdaten und/oder Parametern eines Lade-/Entladevorgangs eines Energiespeichers (10) als Eingabe eine simulierte Vorgangskapazität des Lade-/Entladevorgangs als Ausgabe berechnet;
- ein Black Box Modell; und
- ein physikalisches Modell.

**12.** Verfahren zum Bestimmen eines Alterungszustands eines Energiespeichers (10), umfassend:

- Umfassen von ersten Vorgangsdaten (100) und einer ersten Vorgangskapazität (101) mindestens eines ersten realen Lade-/Entladevorgangs des Energiespeichers (10);
- Erzeugen eines ersten Modells (110) basierend auf den ersten Vorgangsdaten (100) und der ersten Vorgangskapazität (101) für den mindestens einen ersten Lade-/Entladevorgang des Energiespeichers (10), wobei durch Anwenden des ersten Modells (110) auf die ersten Vorgangsdaten (100) eine simulierte Vorgangskapazität (120) des ersten Lade-/Entladevorgangs berechnet wird, die der ersten Vorgangskapazität (101) entspricht;
- Umfassen von zweiten Vorgangsdaten (200) und einer zweiten Vorgangskapazität (201) mindestens eines zweiten Lade-/Entladevorgangs des Energiespeichers (10);
- Bestimmen eines Alterungszustandes des Energiespeichers (10) unter Verwenden des ersten Modells (110), der zweiten Vorgangsdaten (200) und der zweiten Vorgangskapazität (201).

**13.** Computerprogramm, umfassend Befehle, die bei der Ausführung durch einen Prozessor diesen veranlassen, die Schritte des Verfahrens nach Anspruch 12 auszuführen.

**14.** Elektronisch lesbarer Datenträger, insbesondere eine verteilte Datenbank (Cloud), umfassend Befehle, die bei der Ausführung durch einen Prozessor diesen veranlassen, die Schritte des Verfahrens nach Anspruch 12 auszuführen.

## Claims

**1.** Device for determining a state of health of an energy store (10), configured for:

- including first process data (100) and a first process capacity (101) of at least one first real charging/discharging process of the energy store (10);
- generating a first model (110) on the basis of the first process data (100) and the first process capacity (101) for the at least one first charging/discharging process of the energy store (10), wherein, by applying the first model (110) to the first process data (100), a simulated process capacity (120) of the first charging/discharging process is calculated, which simulated process capacity corresponds to the first process capacity (101);
- including second process data (200) and a second process capacity (201) of at least one second charging/-discharging process of the energy store (10);
- determining a state of health of the energy store (10) by using the first model (110), the second process data (200), and the second process capacity (201).

**2.** Device according to Claim 1, wherein the second process data (200) and the second process capacity (201) correspond to a known state of health of the energy store (10), in particular to an initial unaged state of the energy store, and determining a state of health includes comparing a simulated process capacity (120) on the basis of the first model (110) and the second process data (200) with the second process capacity (201).

**3.** Device according to Claim 1, wherein the second process data (200) and the second process capacity (201) correspond at least to a second real charging/discharging process of the energy store (10), which is carried out at a later point in time in particular relative to the at least one first real charging/discharging process.

**4.** Device according to one of the preceding claims, wherein the at least one first charging/discharging process is **characterized by** a first set of parameters (103), and the at least one second charging/discharging process is **characterized by** a second set of parameters (203), and the first and the second sets of parameters (103, 203) include any combination of the following parameters of the respective charging/discharging process:

- an initial voltage (U_BOC);
- a final voltage (U_EOC);
- a maximum current (I_max);
- a mean current during a constant current charging phase (I_mean_CC);
- a mean current during a constant voltage charging phase (I_mean_CV);
- a time period from the beginning of the charging/discharging process at which a switch occurs between a constant current charging phase and a constant voltage charging phase
- a cut-off current (I_EOC),
- a minimum temperature of the energy store (10),
- and a maximum temperature of the energy store (10);
- charging capacity in a constant current charging phase and charging capacity in a constant voltage charging phase;
- discharging capacity in a constant current discharging phase and discharging capacity in a constant voltage discharging phase;
- discharging capacity in the dynamic discharging phase and charging capacity in the recuperation phase;
- charging/discharging parameters under consideration of the polarization of the battery;
- a polarization state of the energy store;
- charging/discharging parameters prior to/during polarization of the battery;
- mean charging/discharge current;
- standard deviation charging/discharge current;
- DC resistance;
- AC resistance;
- load collective of current, voltage, temperature, capacity,
- cycles and half cycles;
- mean temperature;
- maximum temperature;
- mean values of charging/discharging parameters;
- maximum and minimum values of charging/discharging parameters;
- differences between maximum and minimum values (delta calculation); and
- gradients of charging/discharging parameters, in particular dV/dQ, dV/dt, dV/dT, dT/dQ.

**5.** Device according to Claim 4, wherein the first set of parameters (103) at least partially corresponds to the second set of parameters (203) in pairs, and at least some of the values of corresponding parameters (103, 203) are different.

**6.** Device according to one of Claims 3 to 5, wherein determining a state of health of the energy store (10) includes:

- applying the first model (110) to the second process data (200) in order to calculate a simulated process capacity (220) on the basis of the second process data (200) and the first model (110); and
- determining an aging of the energy store (10) by comparing the second process capacity (201) and the simulated process capacity (220) on the basis of the second process data (200) and the first model (130).

**7.** Device according to one of Claims 3 to 5, wherein determining a state of health of the energy store (10) includes:

- applying the first model (110) to the first process data (100) in order to calculate a simulated process capacity (120) on the basis of the first process data (100) and the first model (110);
- determining a first model error of the first model (110), which includes a difference between the first process capacity (101) and the simulated process capacity (120) on the basis of the first parameters (103) and the first model (110);
- generating a second model (210) on the basis of the first process data (100) and the first process capacity (101) as well as on the basis of the second process data (200) and the second process capacity (202);
- applying the second model (230) to the first process data (100) in order to calculate a simulated process capacity (240) on the basis of the first process data (100) and the second model (210);
- applying the second model (210) to the second data in order to calculate a simulated process capacity (240) on the basis of the second process data (200) and the second model (210);
- determining a second model error of the second model (210), which includes a difference between the first process capacity (101) and the simulated process capacity (120) on the basis of the first process data and the second model (210) as well as a difference between the second process capacity (201) and the simulated process capacity (220) on the basis of the second process data (200) and the second model (210);
- determining a state of health of the energy store (10) by comparing the first and the second model errors.

**8.** Device according to Claim 7, wherein generating a second model (210) includes:

- adapting the values of model parameters of the first model (110) while retaining the model parameter by using the second process data (200) and the second process capacity (201) in order to generate the second model (210).

**9.** Device according to one of Claims 3 to 5, wherein determining a state of health of the energy store (10) includes:

- generating a second model (210) on the basis of the second process data (200) and the second process capacity (201) for the at least one second charging/discharging process, wherein, by applying the second model (210) to the second process data (200), a simulated process capacity (220) of the second charging/discharging process is calculated on the basis of the second process data (200) and the second model (210), which simulated process capacity corresponds to the second process capacity (201); and
- comparing at least one model parameter of the first model (130) with at least one model parameter of the second model (230) in order to determine a state of health of the energy store (10).

**10.** Device according to one of Claims 3 to 5, wherein determining a state of health of the energy store (10) includes:

- generating a second model (210) on the basis of the second process data (200) and the second process capacity (201) for the at least one second charging/discharging process, wherein, by applying the second model (210) to the second process data (200), a simulated process capacity (220) of the second charging/discharging process is calculated on the basis of the second process data (200) and the second model (210), which simulated process capacity corresponds to the second process capacity (201); and
- applying the first model (110) to process data of any charging/discharging process in order to calculate a simulated process capacity for the arbitrary charging/discharging process on the basis of the first model (110);
- applying the second model (210) to the process data of the arbitrary charging/discharging process in order to calculate a simulated process capacity for the arbitrary charging/discharging process on the basis of the second model (210);
- determining a state of health of the energy store (10) by comparing the simulated process capacity for the arbitrary charging/discharging process on the basis of the first model (110) and the simulated process capacity for the arbitrary charging/discharging process on the basis of the second model (210).

**11.** Device according to one of the preceding claims, wherein the first model and the second model include one of the following models:

- a regression model on the basis of a regression analysis, which calculates a simulated process capacity of the charging/discharging process by using parameters of a charging/discharging process of an energy store (10);
- a machine learning model which calculates a simulated process capacity of the charging/discharging process as output on the basis of measured data and/or parameters of a charging/discharging process of an energy store (10) as input;
- a black box model; and
- a physical model.

**12.** Method for determining a state of health of an energy store (10), including:

- including first process data (100) and a first process capacity (101) of at least one first real charging/discharging process of the energy store (10);
- generating a first model (110) on the basis of the first process data (100) and the first process capacity (101) for the at least one first charging/discharging process of the energy store (10), wherein, by applying the first model (110) to the first process data (100), a simulated process capacity (120) of the first charging/discharging process is calculated, which simulated process capacity corresponds to the first process capacity (101);
- including second process data (200) and a second process capacity (201) of at least one second charging/-discharging process of the energy store (10);
- determining a state of health of the energy store (10) by using the first model (110), the second process data (200), and the second process capacity (201).

**13.** Computer program, including commands, which, when carried out by a processor, prompt the processor to carry out the steps of the method according to Claim 12.

**14.** Electronically readable data carriers, in particular a distributed database (cloud), including commands, which, when carried out by a processor, prompt the processor to carry out the steps of the method according to Claim 12.

## Revendications

**1.** Appareil permettant de déterminer un état de vieillissement d'un accumulateur d'énergie (10), configuré pour :

- comprendre des premières données de processus (100) et une première capacité de processus (101) d'au moins un premier processus de charge/décharge réel de l'accumulateur d'énergie (10) ;
- générer un premier modèle (110) sur la base des premières données de processus (100) et de la première capacité de processus (101) pour ledit au moins un premier processus de charge/décharge de l'accumulateur d'énergie (10), dans lequel l'application du premier modèle (110) aux premières données de processus (100) permet de calculer une capacité de processus simulée (120) du premier processus de charge/décharge qui correspond à la première capacité de processus (101) ;
- comprendre des deuxièmes données de processus (200) et une deuxième capacité de processus (201) d'au moins un deuxième processus de charge/décharge de l'accumulateur d'énergie (10) ;
- déterminer un état de vieillissement de l'accumulateur d'énergie (10) en utilisant le premier modèle (110), les deuxièmes données de processus (200) et la deuxième capacité de processus (201).

**2.** Appareil selon la revendication 1, dans lequel les deuxièmes données de processus (200) et la deuxième capacité de processus (201) correspondent à un état de vieillissement connu de l'accumulateur d'énergie (10), en particulier à un état non vieilli initial de l'accumulateur d'énergie, et la détermination d'un état de vieillissement comprend une comparaison d'une capacité de processus simulée (120) sur la base du premier modèle (110) et des deuxièmes données de processus (200) avec la deuxième capacité de processus (201).

**3.** Appareil selon la revendication 1, dans lequel les deuxièmes données de processus (200) et la deuxième capacité de processus (201) correspondent au moins à un deuxième processus de charge/décharge réel de l'accumulateur d'énergie (10) qui est exécuté ultérieurement en particulier par rapport audit au moins un premier processus de charge/décharge réel.

**4.** Appareil selon l'une quelconque des revendications précédentes, dans lequel ledit au moins un premier processus de charge/décharge est **caractérisé par** un premier jeu de paramètres (103), et ledit au moins un deuxième processus de charge/décharge est **caractérisé par** un deuxième jeu de paramètres (203), et le premier et le deuxième jeux de paramètres (103, 203) comprennent une combinaison quelconque des paramètres suivants du processus de charge/décharge respectif :

- une tension initiale (U_BOC) ;
- une tension finale (U_EOC) ;
- un courant maximal (I_max) ;
- un courant moyen pendant une phase de charge à courant constant (I_mean_CC) ;
- un courant moyen pendant une phase de charge à tension constante (I_mean_CV) ;

- une durée à partir du début du processus de charge/décharge où on commute entre une phase de charge à courant constant et une phase de charge à tension constante
- un courant de coupure (I_EOC),
- une température minimale de l'accumulateur d'énergie (10),
- et une température maximale de l'accumulateur d'énergie (10) ;
- une capacité de charge dans une phase de charge à courant constant et une capacité de charge dans une phase de charge à tension constante ;
- une capacité de décharge dans une phase de décharge à courant constant et une capacité de décharge dans une phase de décharge à tension constante ;
- une capacité de décharge dans la phase de décharge et une capacité de charge dans la phase de récupération ;
- un paramètre de charge/décharge en tenant compte de la polarisation de la batterie ;
- un état de polarisation de l'accumulateur d'énergie ;
- un paramètre de charge/décharge avant/pendant la polarisation de la batterie ;
- un courant de charge/décharge moyen ;
- un écart-type d'un courant de charge/décharge ;
- une résistance en courant continu ;
- une résistance en courant alternatif ;
- des ensembles de charge du courant, de la tension, de la température et de la capacité,
- des cycles et des demi-cycles ;
- une température moyenne ;
- une température maximale ;
- des moyennes des paramètres de charge/décharge ;
- des valeurs maximales et des valeurs minimales des paramètres de charge/décharge ;
- des différences entre des valeurs maximales et minimales (calcul du delta) ; et
- des gradients des paramètres de charge/décharge, en particulier dV/dQ, dV/dt, dV/dT, dT/dQ.

**5.** Appareil selon la revendication 4, dans lequel le premier jeu de paramètres (103) correspond au moins partiellement par paires au deuxième jeu de paramètres (203), et les valeurs de paramètres (103, 203) qui correspondent les uns aux autres sont au moins partiellement différentes.

**6.** Appareil selon l'une quelconque des revendications 3 à 5, dans lequel la détermination d'un état de vieillissement de l'accumulateur d'énergie (10) comprend :

- l'application du premier modèle (110) aux deuxièmes données de processus (200) pour calculer une capacité de processus simulée (220) sur la base des deuxièmes données de processus (200) et du premier modèle (110) ; et
- la détermination d'un vieillissement de l'accumulateur d'énergie (10) par la comparaison de la deuxième capacité de processus (201) et de la capacité de processus simulée (220) sur la base des deuxièmes données de processus (200) et du premier modèle (130).

**7.** Appareil selon l'une quelconque des revendications 3 à 5, dans lequel la détermination d'un état de vieillissement de l'accumulateur d'énergie (10) comprend :

- l'application du premier modèle (110) aux premières données de processus (100) pour calculer une capacité de processus simulée (120) sur la base des premières données de processus (100) et du premier modèle (110) ;
- la détermination d'une première erreur de modèle du premier modèle (110) qui comprend une différence entre la première capacité de processus (101) et la capacité de processus simulée (120) sur la base des premiers paramètres (103) et du premier modèle (110) ;
- la génération d'un deuxième modèle (210) sur la base des premières données de processus (100) et de la première capacité de processus (101) ainsi que des deuxièmes données de processus (200) et de la deuxième capacité de processus (202) ;
- l'application du deuxième modèle (230) aux premières données de processus (100) pour calculer une capacité de processus simulée (240) sur la base des premières données de processus (100) et du deuxième modèle (210) ;
- l'application du deuxième modèle (210) aux deuxièmes données pour calculer une capacité de processus simulée (240) sur la base des deuxièmes données de processus (200) et du deuxième modèle (210) ;
- la détermination d'une deuxième erreur de modèle du deuxième modèle (210) qui comprend une différence entre la première capacité de processus (101) et la capacité de processus simulée (120) sur la base des premières données de processus et du deuxième modèle (210) ainsi qu'une différence entre la deuxième capacité de processus (201) et la capacité de processus simulée (220) sur la base des deuxièmes données de processus (200) et du deuxième modèle (210) ;
- la détermination d'un état de vieillissement de l'accumulateur d'énergie (10) par la comparaison de la première et de la deuxième erreur de modèle.

**8.** Appareil selon la revendication 7, dans lequel la génération d'un deuxième modèle (210) comprend :

- l'adaptation des valeurs de paramètres de modèle du premier modèle (110) en préservant les paramètres de modèle en utilisant les deuxièmes données de processus (200) et la deuxième capacité de processus (201) pour générer le deuxième modèle (210).

**9.** Appareil selon l'une quelconque des revendications 3 à 5, dans lequel la détermination d'un état de vieillissement de l'accumulateur d'énergie (10) comprend :

- la génération d'un deuxième modèle (210) sur la base des deuxièmes données de processus (200) et de la deuxième capacité de processus (201) pour ledit au moins un deuxième processus de charge/décharge, dans lequel l'application du deuxième modèle (210) aux deuxièmes données de processus (200) permet de calculer une capacité de processus simulée (220) du deuxième processus de charge/décharge sur la base des deuxièmes données de processus (200) et du deuxième modèle (210) qui correspond à la deuxième capacité de processus (201) ; et
- la comparaison d'au moins un paramètre de modèle du premier modèle (130) avec au moins un paramètre de modèle du deuxième modèle (230) pour déterminer un état de vieillissement de l'accumulateur d'énergie (10).

**10.** Appareil selon l'une quelconque des revendications 3 à 5, dans lequel la détermination d'un état de vieillissement de l'accumulateur d'énergie (10) comprend :

- la génération d'un deuxième modèle (210) sur la base des deuxièmes données de processus (200) et de la deuxième capacité de processus (201) pour ledit au moins un deuxième processus de charge/décharge, dans lequel l'application du deuxième modèle (210) aux deuxièmes données de processus (200) permet de calculer une capacité de processus simulée (220) du deuxième processus de charge/décharge sur la base des deuxièmes données de processus (200) et du deuxième modèle (210) qui correspond à la deuxième capacité de processus (201) ;
- l'application du premier modèle (110) à des données de processus d'un processus de charge/décharge quelconque pour calculer une capacité de processus simulée pour le processus de charge/décharge quelconque sur la base du premier modèle (110) ;
- l'application du deuxième modèle (210) aux données de processus d'un processus de charge/décharge quelconque pour calculer une capacité de processus simulée pour le processus de charge/décharge quelconque sur la base du deuxième modèle (210) ;
- la détermination d'un état de vieillissement de l'accumulateur d'énergie (10) par la comparaison de la capacité de processus simulée pour le processus de charge/décharge quelconque sur la base du premier modèle (110) et de la capacité de processus simulée pour le processus de charge/décharge quelconque sur la base du deuxième modèle (210).

**11.** Appareil selon l'une quelconque des revendications précédentes, dans lequel le premier modèle et le deuxième modèle comprennent l'un des modèles suivants :

- un modèle de régression sur la base d'une analyse de régression qui calcule une capacité de processus simulée du processus de charge/décharge en utilisant des paramètres d'un processus de charge/décharge d'un accumulateur d'énergie (10) ;
- un modèle d'apprentissage machine qui calcule sur la base de données mesurées et/ou de paramètres d'un processus de charge/décharge d'un accumulateur d'énergie (10) en entrée une capacité de processus simulée du processus de charge/décharge en sortie ;
- un modèle de boîte noire ; et
- un modèle physique.

**12.** Procédé permettant de déterminer un état de vieillissement d'un accumulateur d'énergie (10), comprenant les étapes consistant à :

- comprendre des premières données de processus (100) et une première capacité de processus (101) d'au moins un premier processus de charge/décharge réel de l'accumulateur d'énergie (10) ;
- générer un premier modèle (110) sur la base des premières données de processus (100) et de la première capacité de processus (101) pour ledit au moins un premier processus de charge/décharge de l'accumulateur d'énergie (10), dans lequel l'application du premier modèle (110) aux premières données de processus (100) permet de calculer une capacité de processus simulée (120) du premier processus de charge/décharge qui correspond à la première capacité de processus (101) ;
- comprendre des deuxièmes données de processus (200) et une deuxième capacité de processus (201) d'au moins un deuxième processus de charge/décharge de l'accumulateur d'énergie (10) ;
- déterminer un état de vieillissement de l'accumulateur d'énergie (10) en utilisant le premier modèle (110), les deuxièmes données de processus (200) et la deuxième capacité de processus (201).

**13.** Programme informatique, comprenant des instructions qui, lorsqu'elles sont exécutées par un processeur, font que celui-ci exécute les étapes du procédé selon la revendication 12.

**14.** Support de données à lecture électronique, en particulier une base de données distribuée (nuage), comprenant des instructions qui, lorsqu'elles sont exécutées par un processeur, font que celui-ci exécute les étapes du procédé selon la revendication 12.

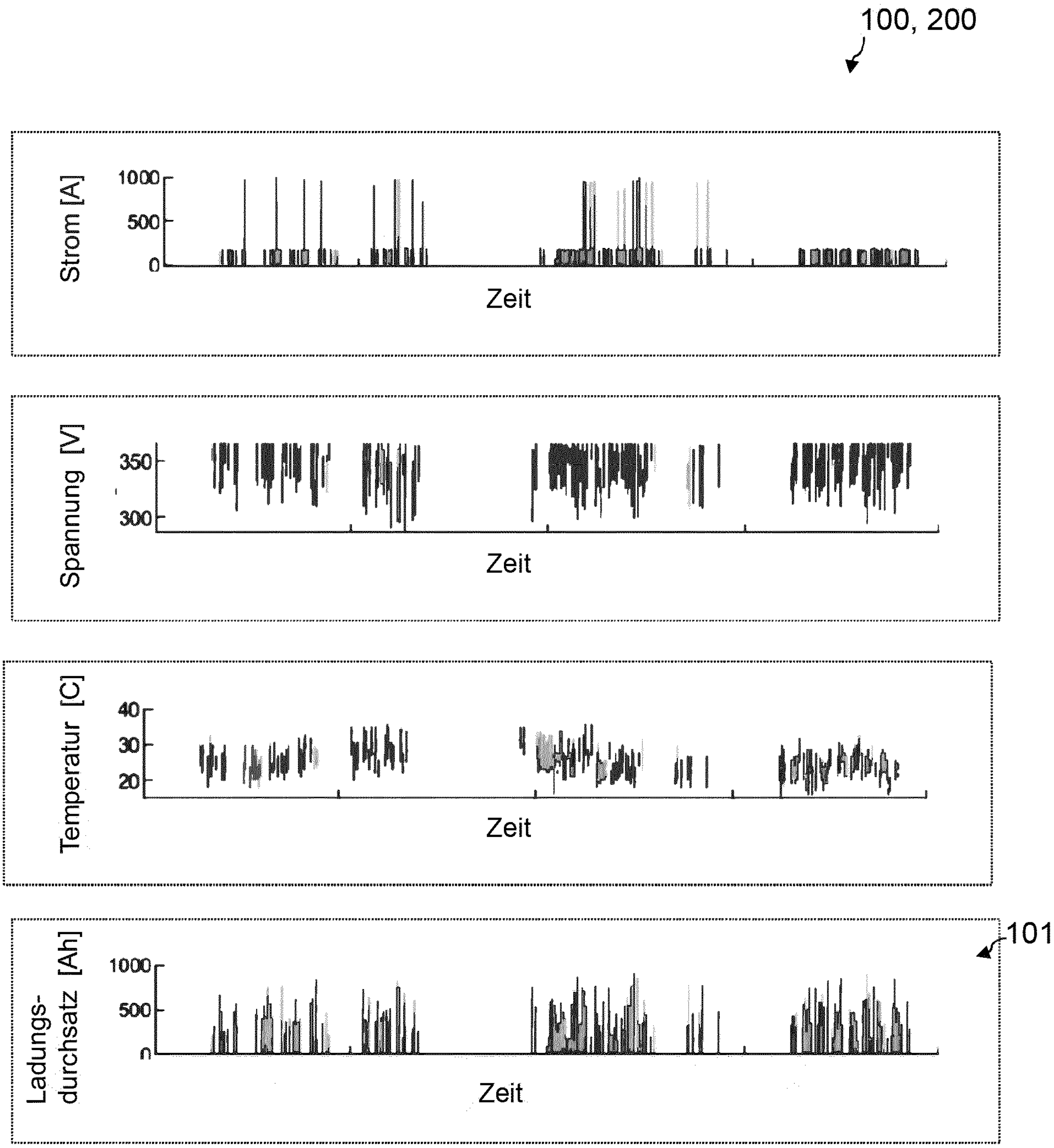
100, 200
Strom [A]
1000
500
0
Zeit
Spannung [V]
350
300
Zeit
Temperatur [C]
40
30
20
Zeit
Ladungs-durchsatz [Ah]
1000
500
0
Zeit
101

FIG. 1

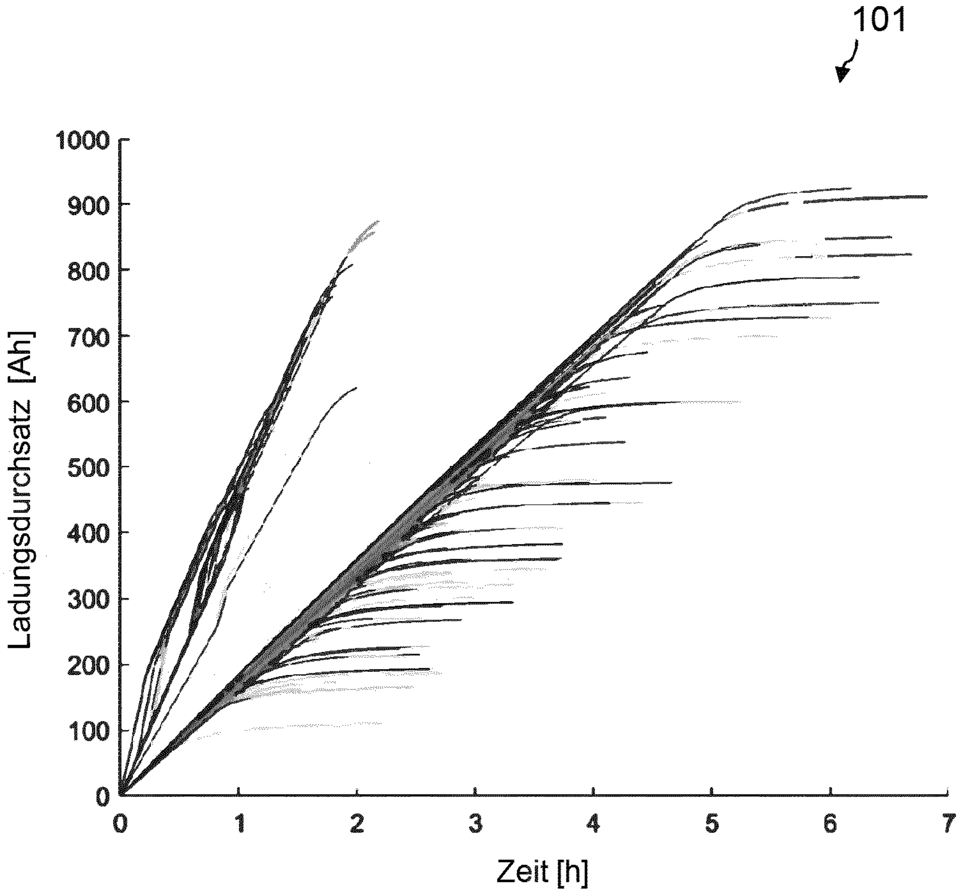
101
1000
900
800
700
600
500
400
300
200
100
0
Ladungsdurchsatz [Ah]
0
1
2
3
4
5
6
7
Zeit [h]

FIG. 2

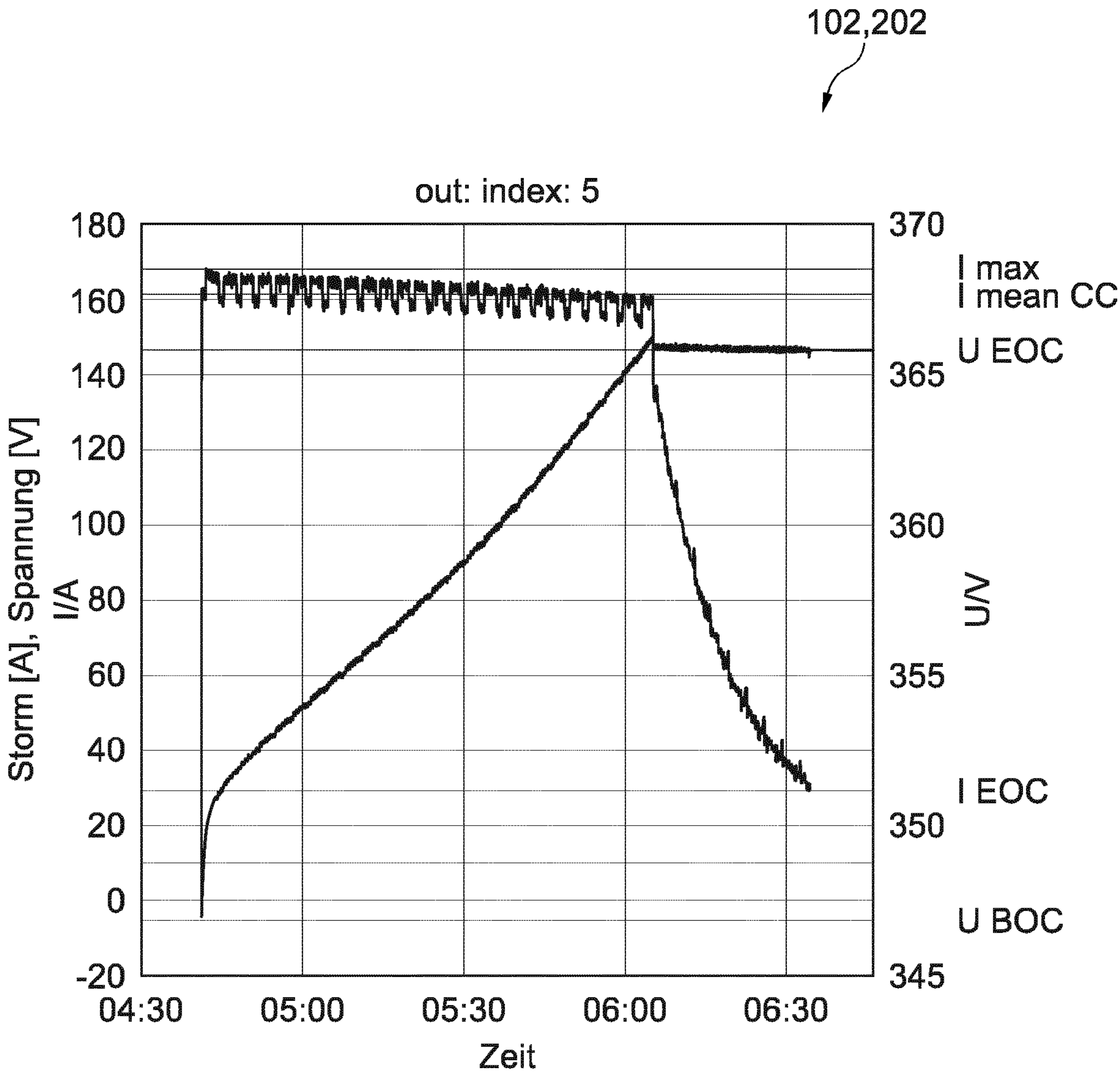
102,202
out: index: 5
180
160
140
120
100
80
60
40
20
0
-20
Storm [A], Spannung [V]
I/A
370
365
360
355
350
345
U/V
I max
I mean CC
U EOC
I EOC
U BOC
04:30
05:00
05:30
06:00
06:30
Zeit

Fig. 3

110, 210

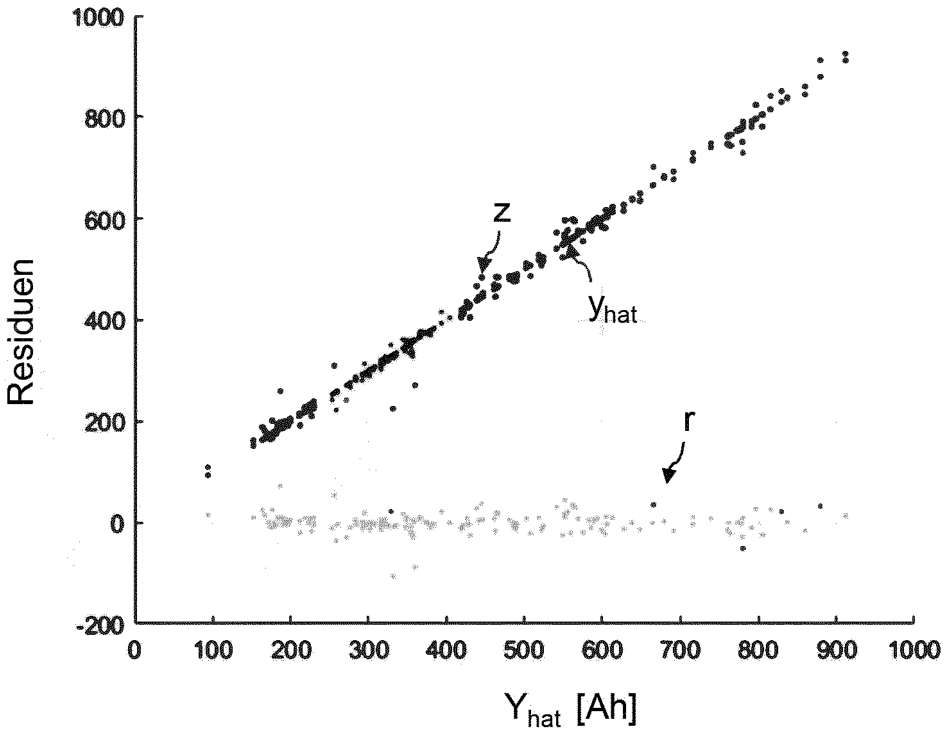
1000
800
600
400
200
0
-200
Residuen
z
$y_{hat}$
r
0
100
200
300
400
500
600
700
800
900
1000
$Y_{hat}$ [Ah]

FIG. 4

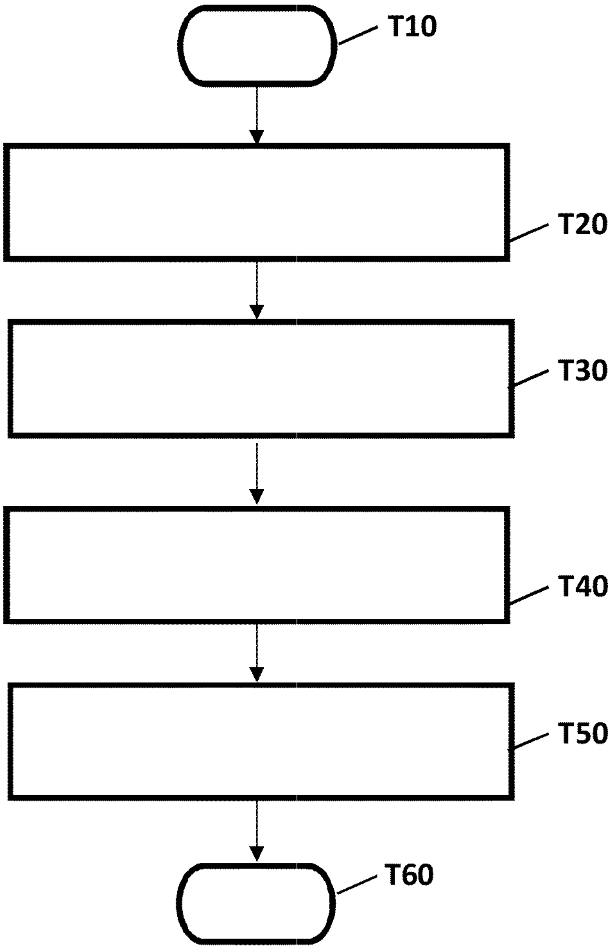


FIG. 5

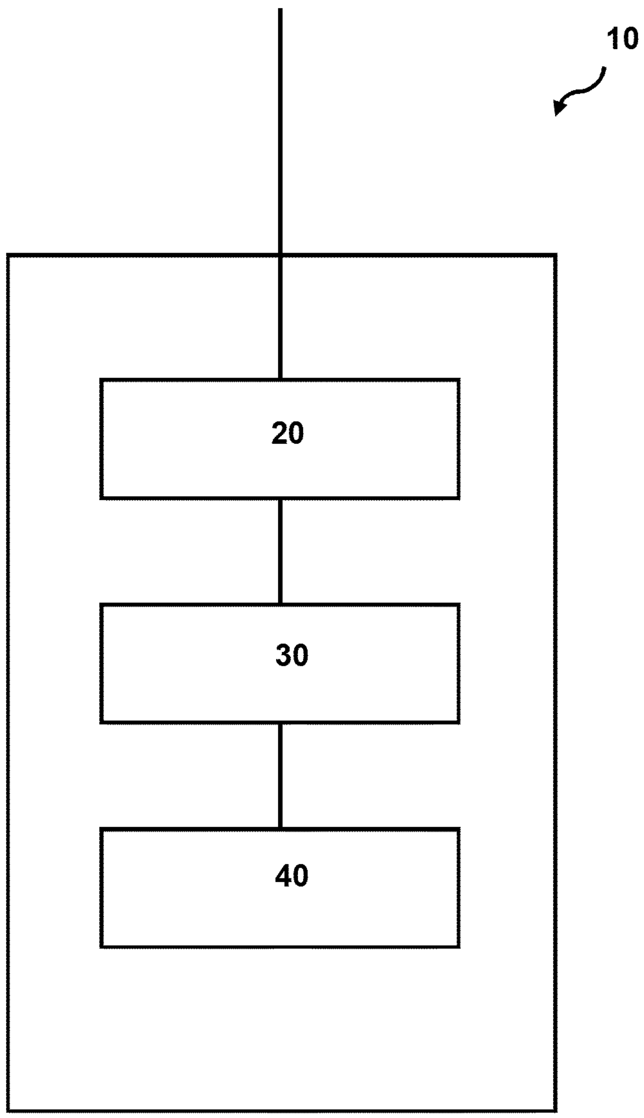


FIG. 6

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- WO 2017142585 A1